(19) Europäisches Patentamt
European Patent Office
Office européen des brevets

(11) **EP 4 300 347 A1**

(12) **EUROPEAN PATENT APPLICATION**

(43) Date of publication:
**03.01.2024 Bulletin 2024/01**

(21) Application number: **23169756.6**

(22) Date of filing: **25.04.2023**

(51) International Patent Classification (IPC):
**G06F 30/20** $^{(2020.01)}$   **G08G 1/01** $^{(2006.01)}$

(52) Cooperative Patent Classification (CPC):
**G06F 30/20; G08G 1/01; G08G 1/0104**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **01.07.2022 JP 2022106776**

(71) Applicant: **FUJITSU LIMITED
Kawasaki-shi, Kanagawa 211-8588 (JP)**

(72) Inventors:
• **ITAKURA, Kota
Kawasaki-shi, Kanagawa 211-8588 (JP)**
• **YAMAOKA, Hisatoshi
Kawasaki-shi, Kanagawa 211-8588 (JP)**
• **TAKAHASHI, Eiichi
Kawasaki-shi, Kanagawa 211-8588 (JP)**

(74) Representative: **Hoffmann Eitle
Patent- und Rechtsanwälte PartmbB
Arabellastraße 30
81925 München (DE)**

(54) **SIMULATION EXECUTION METHOD AND PROGRAM**

(57) A simulation execution method in which a computer executes simulations of traffic dynamics of a moving object a plurality of times by changing a value of a parameter, the simulation execution method comprising includes executing each of the simulations for one of a predetermined number of steps and a predetermined time, obtaining a prediction time taken for completion of each of the simulations, based on information that indicates the traffic dynamics obtained by the executed simulation, and preferentially executing, among each of the simulations, a simulation for which the obtained prediction time is short, after the one of the predetermined number of steps and the predetermined time.

FIG. 1

EP 4 300 347 A1

**Description**

FIELD

The embodiments discussed herein are related to a simulation execution method and a program.

BACKGROUND

A simulation by a computer may be used to solve a complicated city problem or the like. The computer may exhaustively execute a simulation under various conditions. The condition is given as a value of a parameter. For example, a result of the simulation is used for an evaluation and planning of policies from various viewpoints.

A search apparatus is proposed that efficiently searches for a plurality of parameters such as a temperature of a chamber and a type and a concentration of a solution, which determine operation conditions of a manufacturing apparatus that manufactures a chemical substance. According to this proposal, in order to optimize the operation conditions of the manufacturing apparatus, an optimum parameter is exhaustively searched by a grid search or the optimum parameter is stochastically searched by a random search.

Japanese Laid-open Patent Publication No. 2019-152986 is disclosed as related art.

A simulation of a time propagation system such as a traffic simulation may be performed by the grid search method or the random search method. In this case, it may take a long time to obtain a simulation result when one condition, for example, a parameter is set to a certain value. Therefore, it may take time to grasp an overall structure of a distribution of evaluation values and the like obtained as the simulation result under each condition.

SUMMARY

According to one aspect, an object of the present disclosure is to enable acquisition of simulation results for many values at an early timing.

According to an aspect of the embodiments, a simulation execution method in which a computer executes simulations of traffic dynamics of a moving object a plurality of times by changing a value of a parameter, the simulation execution method comprising includes executing each of the simulations for one of a predetermined number of steps and a predetermined time, obtaining a prediction time taken for completion of each of the simulations, based on information that indicates the traffic dynamics obtained by the executed simulation, and preferentially executing, among each of the simulations, a simulation for which the obtained prediction time is short, after the one of the predetermined number of steps and the predetermined time.

BRIEF DESCRIPTION OF DRAWINGS

FIG. 1 is a diagram describing an information processing apparatus according to a first embodiment;
FIG. 2 is a diagram illustrating a hardware example of an information processing apparatus according to a second embodiment;
FIG. 3 a diagram illustrating an evaluation example of policies by a city traffic simulation;
FIGs. 4A and 4B are diagrams illustrating an example of a grid search method and a random search method;
FIG. 5 is a diagram illustrating a functional example of the information processing apparatus;
FIG. 6 is a diagram describing an example of an increase and decrease in the number of vehicles;
FIG. 7 is a diagram describing an example of a route re-search;
FIG. 8 is a diagram illustrating an example of a relationship between a step of the simulation and a vehicle speed;
FIG. 9 is a diagram illustrating an example of policy parameter range information;
FIG. 10 is a diagram illustrating an example of policy parameter information;
FIG. 11 is a diagram illustrating an example of a result output instruction;
FIG. 12 is a diagram illustrating an example of a simulation result table;
FIG. 13 is a diagram illustrating an example of a prediction completion timetable;
FIG. 14 is a diagram illustrating an example of an execution sequence table;
FIG. 15 is a flowchart illustrating an example of acquiring the simulation result table;
FIG. 16 is a flowchart illustrating an example of determining an execution sequence of a simulation;
FIG. 17 is a diagram illustrating an example of a relationship between a time and the number of obtained samples;
FIG. 18 is a diagram illustrating an execution example of the simulation;
FIG. 19 is a diagram illustrating an example of determining an execution sequence according to a third embodiment;

FIG. 20 is a diagram illustrating an example of a priority score table; and

FIG. 21 is a flowchart illustrating another example of determining the execution sequence of the simulation.

DESCRIPTION OF EMBODIMENTS

Hereinafter, embodiments of techniques possible to acquire simulation results for many values at an early timing will be described with reference to the drawings.

First Embodiment

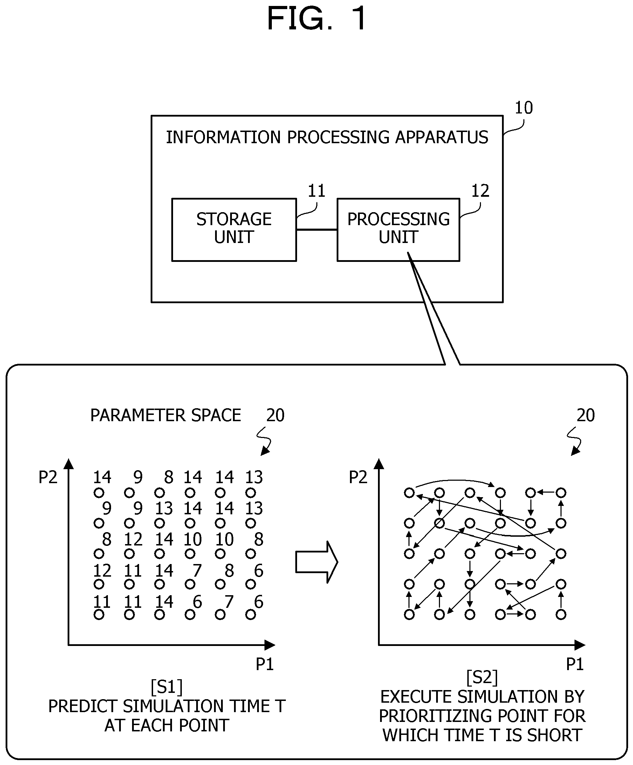

A first embodiment will be described. FIG. 1 is a diagram describing an information processing apparatus according to the first embodiment. An information processing apparatus 10 simulates traffic dynamics of a moving object. The moving object may be a vehicle such as an automobile, a railway vehicle, or a bicycle, or may be a ship or an airplane. The moving object may be a person. The information processing apparatus 10 includes a storage unit 11 and a processing unit 12.

The storage unit 11 may be a volatile storage device such as a random-access memory (RAM), or may be a nonvolatile storage device such as a hard disk drive (HDD) or a flash memory. The processing unit 12 may include a central processing unit (CPU), a digital signal processor (DSP), an application-specific integrated circuit (ASIC), a field-programmable gate array (FPGA), or the like. The processing unit 12 may be a processor that executes a program. The "processor" referred to herein may also include a set of a plurality of processors (multiprocessor).

The storage unit 11 holds values of parameters used for a simulation. As an example, it is assumed that parameters P1 and P2 are used. Meanwhile, the number of parameters may be one or three or more. A set of values of the parameters P1 and P2 is given in advance. The set of the values of the parameters P1 and P2 is represented by a point in a parameter space 20. A horizontal axis of the parameter space 20 is P1. A vertical axis of the parameter space 20 is P2. An example in which respective points are arranged at equal intervals in vertical and horizontal directions is illustrated in the diagram of the parameter space 20. Meanwhile, each point may be randomly determined in the parameter space 20, or may be determined by another method.

In the simulation, a space (for example, a road network, a railway network, a course, or the like of a certain city) and a time (for example, a time range from 8 a.m. to 9 a.m., a time range from 0 a.m. to 0 a.m. of the next day, or the like) of a simulation target are determined in advance. In the simulation, a plurality of moving objects are periodically arranged in the space of the simulation target, for example, a simulation space, and each moving object is simulated to move from an initial position to a destination point. The moving object that reaches the destination is deleted from the simulation space.

An example of a policy evaluation by such a simulation is a road pricing policy evaluation. In the road pricing policy evaluation, a size or the charge amount of a charge area is used as a parameter. The charge area is an area in which a bill is charged when the moving object passes through. The charge amount is the amount of money charged for passing through the charge area. A micro traffic simulation for a predetermined time is performed while changing the size or the charge amount of the charge area, and an evaluation value related to an influence on safety, carbon dioxide emission, regional economy, and the like is calculated in accordance with a set of the size and the charge amount of the charge area.

For each of a plurality of values of the parameter, the processing unit 12 executes a simulation of traffic dynamics by the moving object for a certain number of steps or for a certain time. Based on information indicating the traffic dynamics obtained by the simulation for the certain number of steps or for the certain time, the processing unit 12 predicts a time taken to complete the simulation for each of the plurality of values (S1). A time T taken to complete the simulation may be a length of a time represented by a normal unit such as seconds or minutes, or may simply be an index indicating the length of the time. The time T may be referred to as a prediction time T. For example, the time T may be an index value indicating that the time is longer as the value is larger. The index value may be an index value having a dimension different from a dimension of the time (unit of physical quantity) or may be a dimensionless index value.

One step in the simulation is a process for a unit time of time propagation in the simulation. The unit time of the time propagation is, for example, one second. For example, in a case where time propagation for one hour in total is performed per one second as a unit time, the total number of steps is 3600. A certain number of steps is determined in advance so as to be a very small number (for example, approximately 1% to 10% of the total number of steps or the like) as compared with the total number of steps. The certain time is determined in advance to be a very short time as compared with an approximate desirable time expected for simulations of all the steps with a certain value.

For example, the information indicating the traffic dynamics includes the number or speed of moving objects which exist in the simulation space in each step, and the number of route re-searches performed by the moving object in each step. As the number of moving objects in the simulation space is increased, the number of calculation targets is increased. Therefore, as the number of moving objects in the simulation space is increased, an execution time of the simulations is increased. As the speed of the moving object is decreased, the number of moving objects staying in the simulation space is increased. Therefore, as the speed of the moving object is decreased, the execution time of the simulations is increased.

The route re-search is a process of re-calculating a bypass route for the charge area. For example, in the simulation, in a case where the moving object reaches the charge area, it is determined whether or not to detour based on information on an action characteristic defined in advance for the moving object, and in a case of detouring, the bypass route is calculated again. Therefore, as the number of route re-searches is increased, the execution time of the simulations is increased.

Based on the tendency described above with respect to the execution time of the simulations, the processing unit 12 may obtain the time T by methods of the following first to seventh examples, for example. Meanwhile, the methods of the first to seventh examples are an example, and another method may be used.

With the first example, the processing unit 12 calculates the time T so as to be proportional to the average number of moving objects that exist in the simulation space per step.

With the second example, the processing unit 12 calculates the time T so as to be inversely proportional to the certain number of steps or an average speed of the moving objects in a certain time.

With the third example, the processing unit 12 calculates the time T so as to be proportional to the average number of route re-searches that occur per step.

With the fourth example, the processing unit 12 calculates the time T by combining two or more of the average number of moving objects, the average speed, and the average number of route re-searches described above.

In a case where the average number the average speed of the moving objects are used in the fourth example, the processing unit 12 may calculate the time T such that the time T is proportional to the average number of moving objects that exist in the simulation space per step and is inversely proportional to the average speed of the moving objects in a certain number of steps or a certain time. For example, the processing unit 12 may calculate the time T by using a sum of a term proportional to the average number of moving objects that exist in the simulation space per step and a term inversely proportional to the average speed of the moving object in the certain number of steps or the certain time.

With the fifth example, the processing unit 12 calculates the time T based on a change tendency of the number of moving objects, the speed of the moving object, or the like. For example, the processing unit 12 may obtain a regression line representing a relationship of an average speed of the moving object with respect to the number of steps of the simulation, obtain the average speed of the moving object per step from the regression line, and calculate the time T so as to be inversely proportional to the average speed.

With the sixth example, the processing unit 12 sets the time obtained in the first to fifth examples described above as T1. The processing unit 12 calculates the time T by correcting T1 based on a time u taken to execute the simulation for the certain number of steps. For example, the processing unit 12 may calculate the time T by adding a term proportional to u to T1.

With the seventh example, the processing unit 12 sets the time obtained in the first to fifth examples described above as T1. The processing unit 12 calculates the time T by correcting T1 based on a number s of steps executed in the simulation for the certain time. For example, the processing unit 12 may calculate the time T by adding a term inversely proportional to s to T1.

A diagram corresponding to stage S1 illustrates a numerical value indicating a prediction result of the time T taken to complete the simulation, for each point represented by a set of values of the parameters P1 and P2. A decimal part of the numerical value indicated by stage S1 may be omitted.

The processing unit 12 preferentially executes a simulation for which a predicted time is a short value among the plurality of values of the parameter (S2). For example, for the two parameters P1 and P2, the processing unit 12 executes the simulation by giving priority to a point for which the predicted time T is short among a plurality of points represented by the set of values of the parameters P1 and P2. The processing unit 12 may execute the simulation of each value from a beginning, or may execute the simulation after a certain number of steps or a certain time. In any case, the processing unit 12 preferentially executes a simulation for which the calculated prediction time is short, after the certain number of steps or the certain time.

In this manner, with the information processing apparatus 10, each simulation in which the parameters to be used are changed is executed for the certain number of steps or for the certain time. Based on information indicating the traffic dynamics obtained by the executed simulation, a prediction time taken for completion of each simulation is calculated. Among the respective simulations, a simulation for which a calculated prediction time is short is preferentially executed after the certain number of steps or the certain time.

For example, the information processing apparatus 10 executes the simulation in such a sequence to cover the parameter space 20 as widely as possible at an early stage, in accordance with a prediction of the time taken to complete the simulation at each point in the parameter space 20. Therefore, even at a stage at which the simulation is not completed for all the points in the parameter space 20, the information processing apparatus 10 may support a user to quickly grasp a distribution or the like of approximate evaluation values corresponding to more points. The information processing apparatus 10 may support early determination such as interruption of the simulation, and may also suppress a cost for the calculation.

Second Embodiment

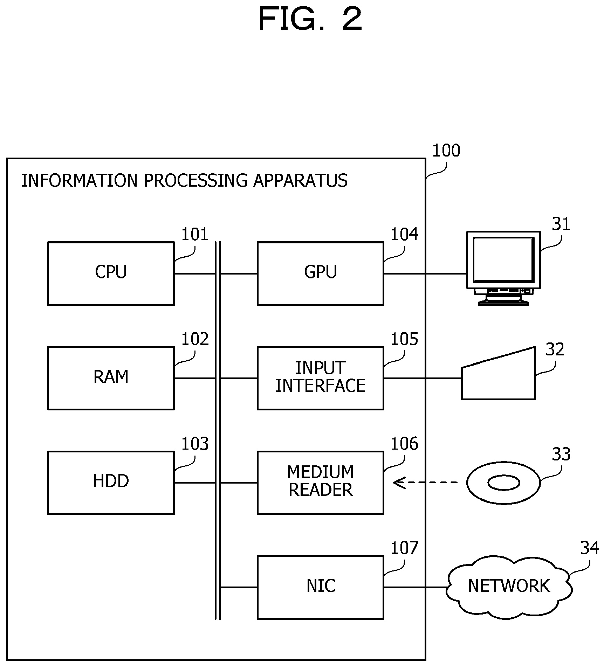

Next, a second embodiment will be described. FIG. 2 is a diagram illustrating a hardware example of an information processing apparatus according to a second embodiment.

An information processing apparatus 100 includes a CPU 101, a RAM 102, an HDD 103, a graphics processing unit (GPU) 104, an input interface 105, a medium reader 106, and a network interface card (NIC) 107. The CPU 101 is an example of the processing unit 12 according to the first embodiment. The RAM 102 or the HDD 103 is an example of the storage unit 11 according to the first embodiment.

The CPU 101 is a processor that executes a command of a program. The CPU 101 loads at least a part of a program or data stored in the HDD 103 into the RAM 102, and executes the program. The CPU 101 may include a plurality of processor cores. The information processing apparatus 100 may have a plurality of processors. Processes described below may be executed in parallel by using a plurality of processors or processor cores. A set of the plurality of processors may be referred to as a "multiprocessor" or simply referred to as a "processor".

The RAM 102 is a volatile semiconductor memory that temporarily stores the program executed by the CPU 101 or data used for an arithmetic operation by the CPU 101. The information processing apparatus 100 may include memories of types other than the RAM, and may include a plurality of memories.

The HDD 103 is a non-volatile storage device that stores programs of software such as an operating system (OS), middleware, or application software, and data. The information processing apparatus 100 may include other types of storage devices such as a flash memory and a solid-state drive (SSD), and may include a plurality of non-volatile storage devices.

In accordance with a command from the CPU 101, the GPU 104 outputs an image to a display 31 coupled to the information processing apparatus 100. As the display 31, a freely-selected type of display such as a cathode ray tube (CRT) display, a liquid crystal display (LCD), a plasma display, and an organic electro-luminescence (OEL) display may be used.

The input interface 105 acquires an input signal from an input device 32 coupled to the information processing apparatus 100 and outputs the input signal to the CPU 101. As the input device 32, a pointing device such as a mouse, a touch panel, a touch pad, and a trackball, a keyboard, a remote controller, a button switch, and the like may be used. A plurality of types of input devices may be coupled to the information processing apparatus 100.

The medium reader 106 is a reading device that reads a program and data recorded in a recording medium 33. As the recording medium 33, a magnetic disk, an optical disk, a magneto-optical (MO) disk, a semiconductor memory, and the like may be used, for example. The magnetic disk includes a flexible disk (FD) or an HDD. The optical disk includes a compact disc (CD) or a Digital Versatile Disc (DVD).

The medium reader 106 copies the program and the data read from the recording medium 33 to a different recording medium such as the RAM 102 and the HDD 103. The read program is executed by, for example, the CPU 101. The recording medium 33 may be a portable-type recording medium and may be used to distribute the program and the data in some cases. The recording medium 33 or the HDD 103 may be referred to as a computer-readable recording medium.

The NIC 107 is an interface that is coupled to a network 34 and that performs communication with another computer through the network 34. The NIC 107 is coupled to, for example, a communication device such as a switch or a router through a cable. The NIC 107 may be a wireless communication interface.

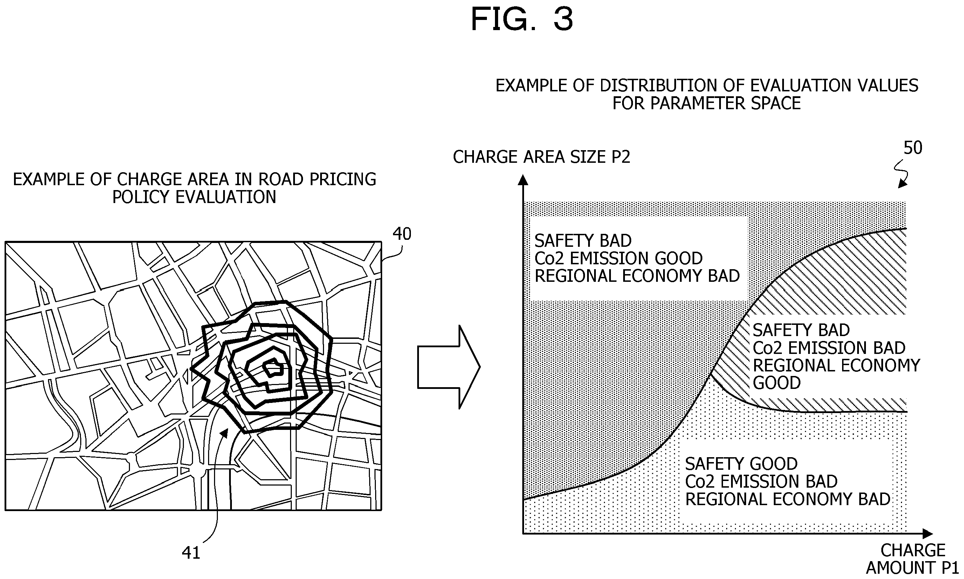

FIG. 3 is a diagram illustrating an evaluation example of a policy by a city traffic simulation. As an example of the simulation executed by the information processing apparatus 100, the city traffic simulation is described. The city traffic simulation is used for road pricing policy evaluation, for example. In such a simulation, a space (for example, a road network of a certain city) and a time (for example, a time range from 8 a.m. to 9 a.m.) to be simulated are determined in advance.

For example, a simulation space 40 indicates a road network through which vehicles such as automobiles may pass in a certain city. A charge area 41 is an area in which a bill is charged for passage of vehicles in the simulation space 40. For example, the charge area 41 is provided with a specific point in the simulation space 40 as a center. For the road pricing policy evaluation, two types of parameters, for example, a size of the charge area 41 and the charge amount are used. The charge area 41 is designated by designating a vertex of a polygon corresponding to the charge area 41. An area of the polygon corresponding to the charge area 41 corresponds to a size of the charge area 41. Therefore, for example, the size of the charge area 41 is designated by designating the charge area 41.

The information processing apparatus 100 performs the micro traffic simulation for a predetermined time while changing the size or the charge amount of the charge area 41. According to a set of the size and the charge amount of the charge area 41, the information processing apparatus 100 calculates evaluation values of safety, carbon dioxide emission (Co2 emission), regional economy, and the like. A distribution 50 illustrates an example of a qualitative distribution of evaluation values for a parameter space. An example of the parameter space has a horizontal axis indicating the charge amount and a vertical axis indicating the size of the charge area 41. The charge amount is an example of the first parameter P1. The size of the charge area 41 is an example of the second parameter P2.

The distribution 50 indicates a tendency of evaluation values representing quality of safety, Co2 emission, and regional economy, in accordance with a set of values set for the size of the charge area 41 and the charge amount. For example, in consideration of policies by experts, an appropriate policy is determined based on the tendency of the evaluation values in the distribution 50. Therefore, it is important to obtain the distribution 50.

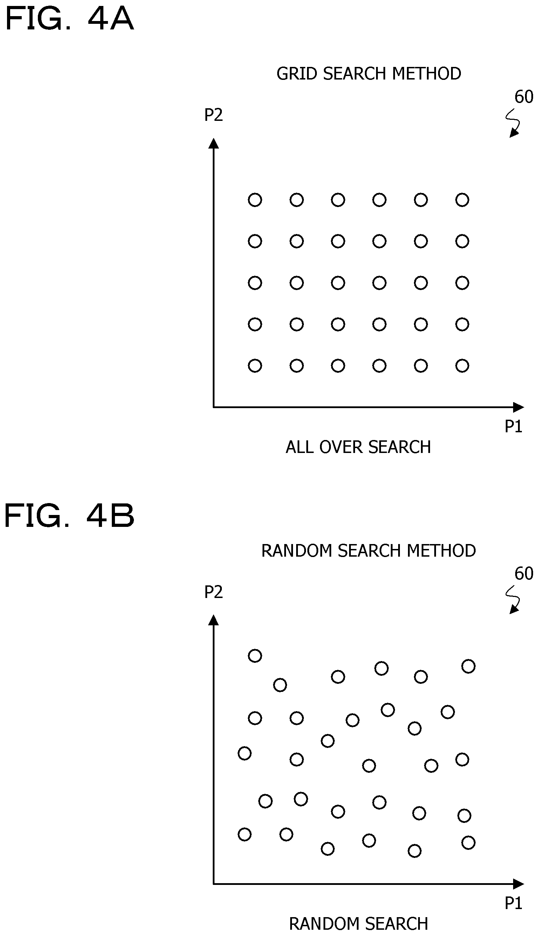

FIGs. 4A and 4B are diagrams illustrating an example of a grid search method and a random search method. The grid search method or the random search method in which values of parameters are sampled from a parameter space 60 according to a specific rule and a simulation is repeated is used to acquire the distribution 50. For the parameter space 60, the horizontal axis (P1) represents the charge amount, and the vertical axis represents the size (P2) of the charge area 41.

FIG. 4A illustrates an example of the grid search method. The grid search method is a method of exhaustively searching the parameter space 60 all over while shifting points in the parameter space 60 in accordance with a certain rule. The searching here corresponds to execution of the simulation. FIG. 4B illustrates an example of the random search method. The random search method is a method of searching by randomly using points in the parameter space 60.

Meanwhile, when the grid search method or the random search method is simply performed, it takes a long time to obtain one sample value, for example, an evaluation value for one point in the parameter space 60 in the simulation in a time propagation type such as the traffic simulation. Therefore, it takes time to grasp the entire structure of the distribution 50 illustrated in FIG. 3.

The information processing apparatus 100 provides a function of obtaining evaluation values at an early stage for a relatively large number of points in the parameter space 60.

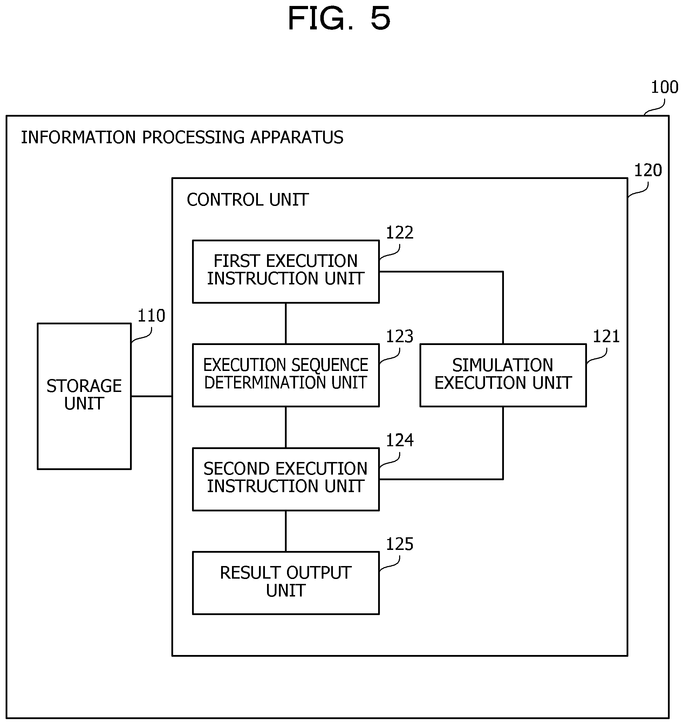

FIG. 5 is a diagram illustrating a functional example of the information processing apparatus. The information processing apparatus 100 includes a storage unit 110 and a control unit 120. A storage region of the RAM 102 or the HDD 103 is used for the storage unit 110. The control unit 120 may be implemented by the CPU 101 executing a program stored in the RAM 102.

The storage unit 110 stores a range of values of parameters used for a simulation and information obtained as a result of the simulation. The storage unit 110 stores information indicating an execution sequence of the simulation for each value of the parameter. The information indicating the execution sequence of the simulation for each parameter value is determined by the control unit 120.

The control unit 120 controls execution of the simulation. The control unit 120 includes a simulation execution unit 121, a first execution instruction unit 122, an execution sequence determination unit 123, a second execution instruction unit 124, and a result output unit 125.

The simulation execution unit 121 executes a simulation. Simulation environment setting information is set in advance in the simulation execution unit 121. The simulation environment setting information includes a road network topology, vehicle arrangement information, and vehicle action characteristic information.

The road network topology indicates road arrangement in the simulation space 40. As the vehicle arrangement information, information on vehicles to be arranged in the simulation space 40 in each step of the simulation is defined. The vehicle arrangement information includes information on an initial position and a destination point of the vehicle. The vehicle action characteristic information defines an action characteristic in route selection of the vehicle. The vehicle action characteristic information includes information on a probability of performing route re-search when the vehicle reaches a charge area. As an example, it is assumed that one step in the simulation corresponds to one second of time propagation in the simulation.

According to an instruction from the first execution instruction unit 122, the simulation execution unit 121 executes a simulation for a certain number of steps or for a certain time for each value of the parameter. The certain number of steps is determined in advance so as to be a very small number (for example, approximately 1% to 10% of the total number of steps or the like) as compared with the total number of steps corresponding to the entire time of a simulation target. The certain time is determined in advance to be a very short time as compared with an approximate desirable time expected for simulations of all the steps with a certain value.

The simulation execution unit 121 responds to the first execution instruction unit 122 with information to be used for sequence control of simulations, the information being obtained by the simulations for the certain number of steps or for the certain time. The information used for the sequence control of the simulations includes information indicating traffic dynamics of vehicles. For example, the information indicating the traffic dynamics includes the number or speed of vehicles that exist in the simulation space 40 in each step and the number of route re-searches performed in each step.

According to an instruction from the second execution instruction unit 124, the simulation execution unit 121 executes the simulation of all steps for each value of the parameter. During the execution of the simulation in all steps, the simulation execution unit 121 responds to the second execution instruction unit 124 with an evaluation value calculated for each value of the parameter. At this time, the simulation execution unit 121 executes the simulation of all the steps by using each value of the parameter in a sequence instructed by the second execution instruction unit 124.

The first execution instruction unit 122 instructs the simulation execution unit 121 to execute the simulation for the certain number of steps or for the certain time for each value of the parameter. The instruction from the first execution instruction unit 122 to the simulation execution unit 121 includes a value of a parameter to be used, information on the number of execution steps or an execution time, and an output instruction of information to be used for sequence control. As described above, there are one or more types of parameters. For example, in a case of two types such as the parameters P1 and P2, "each value of parameter" corresponds to "each set of value of parameter P1 and value of parameter P2". The same applies to a case where there are three or more types of parameters. The output instruction of the information to be used for the sequence control is referred to as a result output instruction.

The execution sequence determination unit 123 acquires, from the first execution instruction unit 122, the information for the sequence control obtained by the simulations for the certain number of steps or for the certain time by the simulation execution unit 121. Based on the information for the sequence control, the execution sequence determination unit 123 predicts a time taken to execute the simulations for all the steps for each value of the parameter. Based on the time T predicted for each value of the parameter, the execution sequence determination unit 123 determines an execution sequence of the simulations of all the steps for each value of the parameter. For example, the execution sequence determination unit 123 determines the execution sequence such that the simulation is executed with priority given to a value having the shorter time T. The execution sequence determination unit 123 notifies the second execution instruction unit 124 of the determined execution sequence.

The second execution instruction unit 124 instructs the simulation execution unit 121 to execute the simulations in all the steps. The instruction from the second execution instruction unit 124 to the simulation execution unit 121 includes a value of a parameter to be used and an output instruction of an evaluation value designated by a user. According to the execution sequence determined by the execution sequence determination unit 123, the second execution instruction unit 124 instructs the simulation execution unit 121 of the value of the parameter to be used.

Via the second execution instruction unit 124, the result output unit 125 acquires an evaluation value obtained as a result of the simulation from the simulation execution unit 121, and presents the evaluation value to the user. Every time the simulation for the value is completed, the result output unit 125 acquires the evaluation value for each value of the parameter, and presents the evaluation value to the user by displaying the evaluation value on the display 31. For example, every time the simulations of all steps for a certain point are completed in the parameter space 60, the user may sequentially check an evaluation value corresponding to the point.

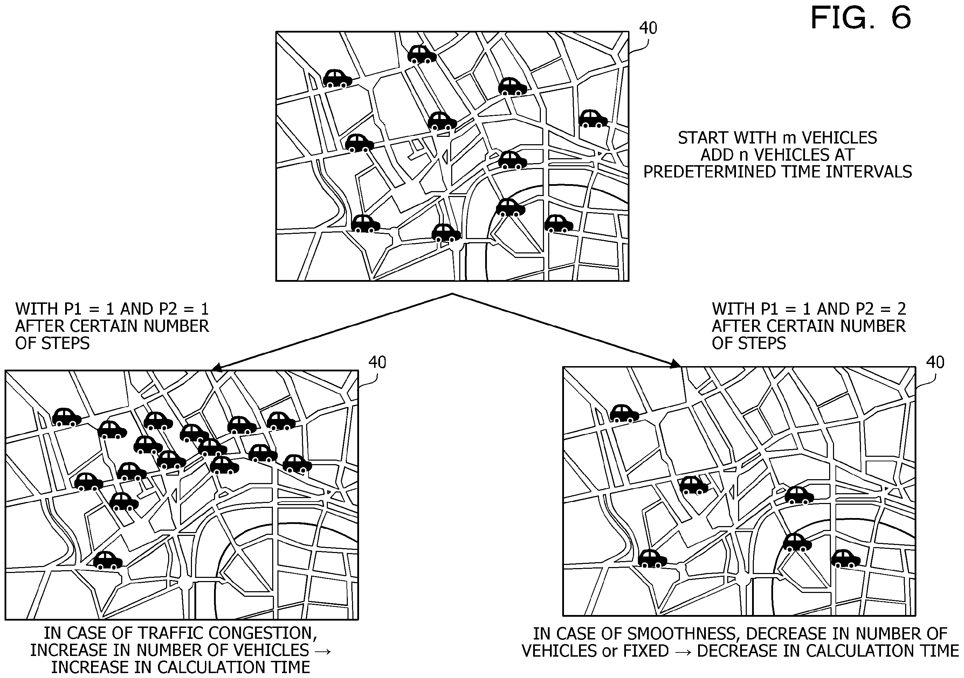

An influence of the traffic dynamics of the vehicles on an execution time of the simulation will be described. FIG. 6 is a diagram describing an example of an increase and decrease in the number of vehicles. First, the simulation execution unit 121 starts a simulation with m vehicles, and adds n vehicles at a predetermined time interval such as every minute in a simulation target time. As an example, m = 5000 and n = 100.

In this case, as the number of vehicles in the simulation space 40 is increased, it takes more time to perform the calculation. In a case where the simulation is performed while changing the charge amount and a size of a charge area, the total number of vehicles put into the simulation space 40 is not changed. Meanwhile, a difference in number of vehicles occurs depending on the vehicles that arrive at a destination and disappear, and the calculation amount is changed.

For example, in a case where traffic congestion occurs after the simulation is executed for a certain number of steps with P1 = 1 and P2 = 1, the number of vehicles in the simulation space 40 is increased. Therefore, a calculation time is increased.

For example, in a case where the vehicles smoothly arrive at the destination points after the simulation is executed for the certain number of steps with P1 = 1 and P2 = 2, the number of vehicles in the simulation space 40 is decreased or the number of vehicles becomes fixed. Therefore, the calculation time is reduced as compared with the case where the traffic congestion occurs.

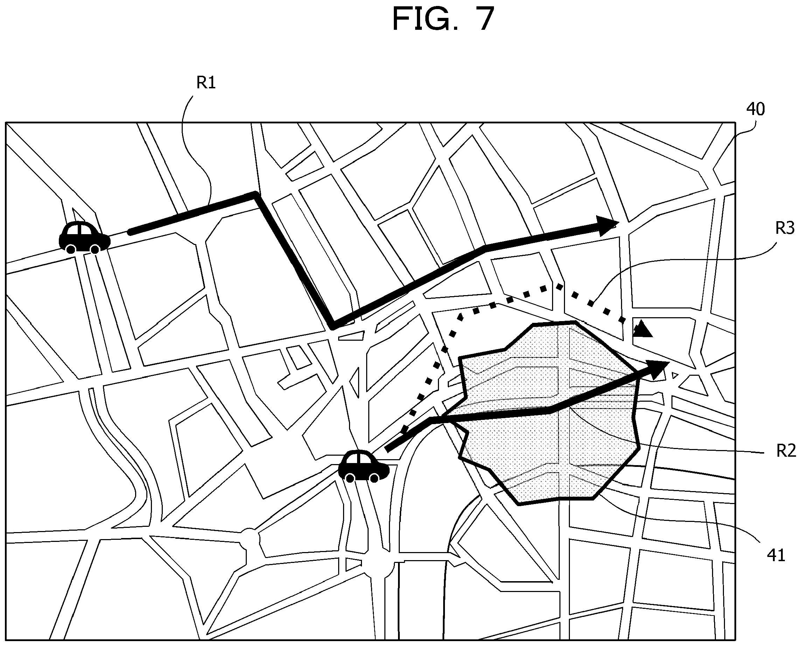

FIG. 7 is a diagram describing an example of a route re-search. Routes R1 and R2 indicate routes along which each vehicle passes from initial positions to destination points. The route R1 is a route that does not pass through the charge area 41. The route R2 is a route that passes through the charge area 41.

Since the route R1 does not pass through the charge area 41, a route re-search is not performed. By contrast, in a case of the route R2, when the vehicle reaches the charge area 41, it is determined whether or not to perform the route re-search. Whether or not to perform the route re-search is determined based on the vehicle action characteristic information described above. For the route re-search, a bypass road R3 to the destination point is recalculated. Therefore, when the number of route re-searches is increased, a calculation time is increased.

As illustrated in FIGs. 6 and 7, the traffic dynamics of the vehicle affect an execution time of a simulation. The execution sequence determination unit 123 calculates the time T taken to execute the simulation as follows, based on information on the traffic dynamics acquired for each value of a parameter by executing the simulation for a certain number of steps or for a certain time.

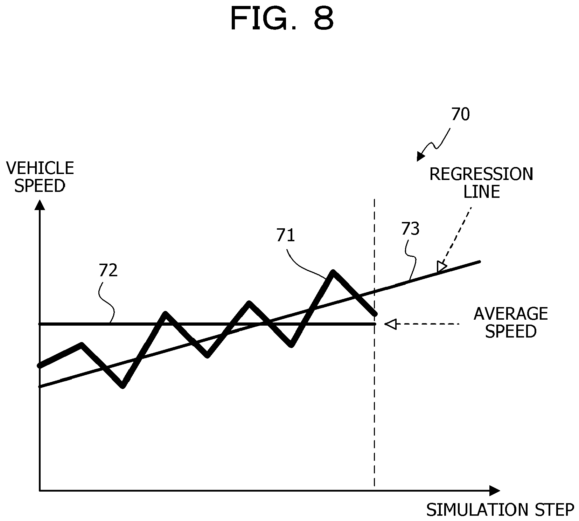

FIG. 8 is a diagram illustrating an example of a relationship between a step of a simulation and a vehicle speed. A graph 70 illustrates a relationship between the number of steps of the simulation (simulation step) and the vehicle speed. A horizontal axis in the graph 70 indicates the simulation step, and a vertical axis indicates the vehicle speed. A series 71 indicates an average speed of a vehicle for each step. A series 72 indicates an average speed of the vehicle in a certain number of steps. A series 73 indicates a regression line representing a change tendency of the average speed of the vehicle for each step. A vertical broken line in the graph 70 indicates a timing corresponding to the certain number of steps or a certain time.

For example, the execution sequence determination unit 123 may obtain the time T based on an average speed $v_{ave}$ of the vehicle in the certain number of steps or the certain time. The time T may be an index value representing a length of a time. Therefore, the time T may also be referred to as a prediction completion time index T. The average speed $v_{ave}$ corresponding to the series 72 is calculated by the following equation.

$$v_{ave} = \text{(total travel distance of all vehicles in a certain number of steps)}/\text{(total travel time of all vehicles in a certain number of steps)}$$

In a case where a simulation is executed for a certain time in order to obtain information for sequence control, the "certain number of steps" in the equation described above may be replaced with the "certain time". Alternatively, in a case where the simulation is executed for a certain time in order to obtain information for sequence control, $v_{ave}$ may be calculated by using the "certain number of steps" in the equation described above as the number of steps executed during the certain time.

In a case where $v_{ave}$ described above is used, the time T is obtained by Equation (1).

$$T = \frac{a}{v_{ave}} + b \tag{1}$$

Wherein a and b are positive coefficients given in advance.

The average speed of the vehicle in a step t may be calculated by the following Equation (2) corresponding to the regression line of the series 73.

$$v_{ave}(t) = 0.2t + 37 \tag{2}$$

A value 37 of a coefficient 0.2 or a constant term is an example, and the value of the coefficient or the constant term may be changed in accordance with the speed obtained for each vehicle in each step. In a case where $v_{ave}(t)$ is represented by Equation (2), the time T may be calculated by Equation (3).

$$T = a \cdot \frac{t_{all}}{\sum_{t=0}^{t=t_{all}} v_{ave}(t)} + b \tag{3}$$

$t_{all}$ may be a certain number of steps of the simulation executed to obtain the information for the sequence control, or may be the total number of steps of the simulation target.

The execution sequence determination unit 123 may obtain the time T based on the number of vehicles in a certain number of steps or in a certain time. For example, it is assumed that the number of vehicles in the certain step t is n(t). An average number $n_{ave}$ of vehicles in steps 0 to k is calculated by Equation (4).

$$n_{ave} = \frac{\sum_{t=0}^{k} n(t)}{k} \tag{4}$$

Assuming that the time T is proportional to the average number $n_{ave}$ of vehicles, the time T is calculated by Equation (5).

$$T = A \cdot \frac{\sum_{t=0}^{k} n(t)}{k} \tag{5}$$

A is a positive coefficient determined in advance. A may be ignored at comparison.

The execution sequence determination unit 123 may obtain the time T based on the number of route re-searches in a certain number of steps or a certain time. For example, it is assumed that the number of vehicles that perform the route re-search in the certain step t is c(t). An average number $c_{ave}$ of route re-searches from steps 0 to k is calculated by Equation (6).

$$c_{ave} = \frac{\sum_{t=0}^{k} c(t)}{k} \tag{6}$$

Assuming that the time T is proportional to the average number $c_{ave}$ of route re-searches, the time T is calculated by Equation (7).

$$T = B \cdot \frac{\sum_{t=0}^{k} c(t)}{k} \tag{7}$$

B is a positive coefficient determined in advance. B may be ignored at comparison.

The execution sequence determination unit 123 may obtain the time T by combining a plurality of types of indices related to traffic dynamics such as the number of vehicles and an average speed. In this case, the time T is calculated by a weighted linear sum of at least two terms on the right sides of Equations (1), (3), (5), and (7). In this manner, even in a case where a variation occurs in individual indices, the variation may be suppressed by combining the plurality of indices. For example, in a case where the number of vehicles and the number of route re-searches are used, the time T is calculated by Equation (8).

$$T = A \cdot \frac{\sum_{t=0}^{k} n(t)}{k} + B \cdot \frac{\sum_{t=0}^{k} c(t)}{k} \tag{8}$$

In order to obtain the information for the sequence control, the execution sequence determination unit 123 may obtain the time T by combining the number s of steps executed in a case where a simulation is executed for a certain time with information on the traffic dynamics such as the average speed. In this case, it is estimated that the time T is decreased as the number s of steps is increased. The time T is calculated by, for example, Equation (9).

$$T = A \cdot \frac{\sum_{t=0}^{k} n(t)}{k} + \frac{B}{s} \tag{9}$$

The execution sequence determination unit 123 may obtain the time T by combining a time u taken in a case of executing the simulation a certain number of steps so as to obtain the information for the sequence control with the information on the traffic dynamics such as the average speed. In this case, it is estimated that the time u is decreased, as the time T is decreased. The time T is calculated by, for example, Equation (10).

$$T = A \cdot \frac{\sum_{t=0}^{k} n(t)}{k} + uB \tag{10}$$

In this manner, the execution sequence determination unit 123 may predict the time T, based on the information on the traffic dynamics obtained by the simulation for the certain number of steps or for the certain time.

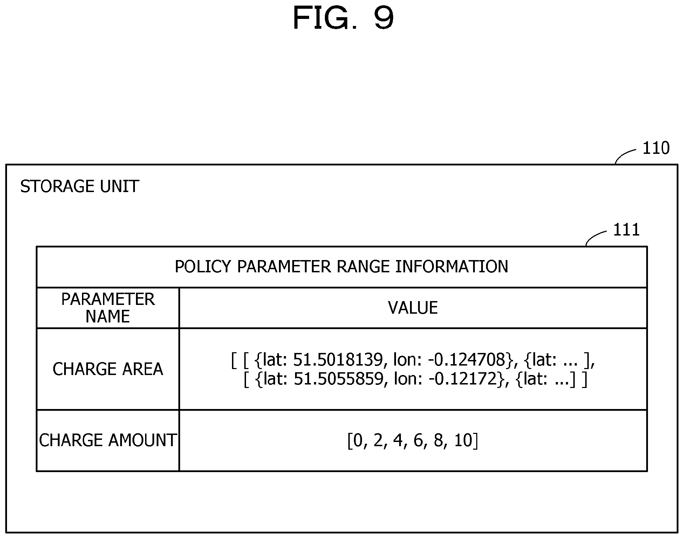

Next, an example of information held by the information processing apparatus 100 will be described. FIG. 9 is a diagram illustrating an example of policy parameter range information. Policy parameter range information 111 is stored in the storage unit 110 in advance. The policy parameter range information 111 includes items of a parameter name and a value. A name of a parameter, for example, the parameter name is registered in the item of the parameter name. A range in which the value of the parameter set for the corresponding parameter may be obtained, for example, a candidate for the value of the parameter is set in the item of the value.

For example, the policy parameter range information 111 has a record with a parameter name "charge area" and a value "[[{lat:51.5018139, lon:-0.124708}, {lat:...], [{lat:51.5055859, lon:-0.12172}, {lat:...]]". This record indicates a candidate for a value that may be set for a parameter with the parameter name "charge area". lat is an abbreviation for latitude. lon is an abbreviation for longitude. The charge area is represented by a polygon having a plurality of vertices designated by coordinates of latitude and longitude. An area of the polygon corresponds to a size of the charge area. For example, a charge area used in a simulation is prepared in stages from a narrow charge area to a wide charge area with a specific point in the simulation space 40 as a center. One charge area has a certain size. One polygon indicating a charge area corresponds to a size of one charge area.

The policy parameter range information 111 has a record of a parameter name "charge amount" and a value "0, 2, 4, 6, 8, 10". This record indicates that a candidate for a value that may be set for a parameter with the parameter name "charge amount" is "0, 2, 4, 6, 8, 10". A unit of the charge amount is, for example, a currency unit such as pounds, dollars, or yen used in the corresponding city.

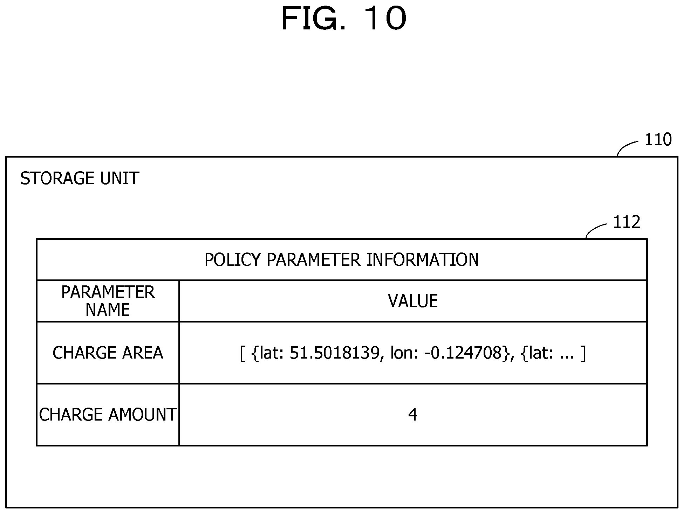

FIG. 10 is a diagram illustrating an example of policy parameter information. Policy parameter information 112 is held in the storage unit 110. The policy parameter information 112 indicates a value of a parameter used to execute a simulation. The value of the parameter is extracted from the policy parameter range information 111 by the first execution instruction unit 122 and the second execution instruction unit 124. The policy parameter information 112 is input to the simulation execution unit 121 by the first execution instruction unit 122 and the second execution instruction unit 124.

The policy parameter information 112 includes items of a parameter name and a value. The parameter name is registered in the item of the parameter name. The value set for a parameter is registered on the item of the value.

For example, the policy parameter information 112 has a record with a parameter name "charge area" and a value "[{lat:51.5018139, lon:-0.124708}, {lat:...]". This record indicates that a plurality of vertices of a polygon corresponding to the charge area indicated by "[{lat:51.5018139, lon:-0.124708}, {lat:...]" are set for the parameter with the parameter name "charge area".

The policy parameter information 112 has a record with a parameter name "charge amount" and a value "4". This record indicates that the value "4" is set for a parameter with the parameter name "charge amount".

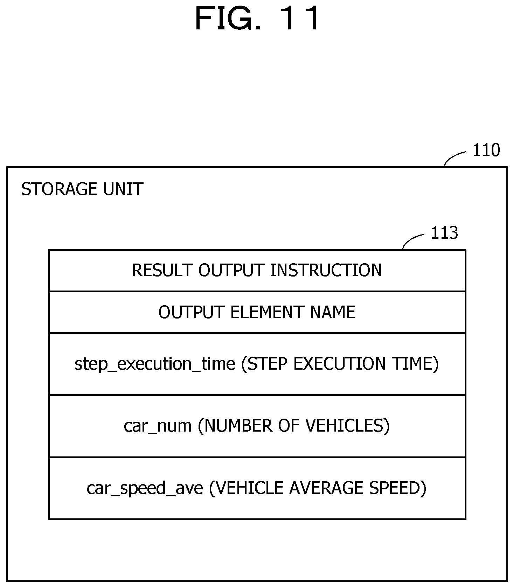

FIG. 11 illustrates an example of a result output instruction. A result output instruction 113 is input to the simulation execution unit 121 by the first execution instruction unit 122. The result output instruction 113 is held in the storage unit 110. The result output instruction 113 includes designation of an element name to be output by the simulation execution unit 121, for example, an output element name. In the example of the result output instruction 113, "step_execution_time" (step execution time), "car_num" (the number of vehicles), and "car_speed_ave" (vehicle average speed) are designated as the output element names.

As "step_execution_time", "car_num", and "car_speed_ave", the simulation execution unit 121 responds to the first execution instruction unit 122 with a value per step.

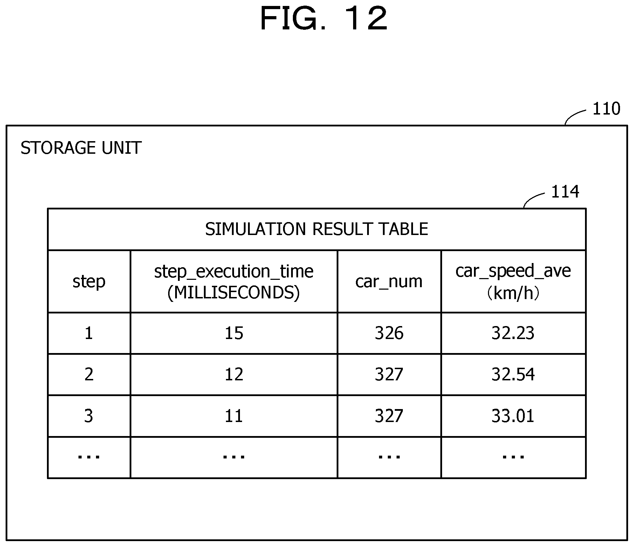

FIG. 12 is a diagram illustrating an example of a simulation result table. A simulation result table 114 is generated by the first execution instruction unit 122 based on information output by the simulation execution unit 121, and is stored in the storage unit 110. The simulation result table 114 includes items of step, step_execution_time, car_num, and car_speed_ave. Each item illustrated in the simulation result table 114 corresponds to each item designated by the result output instruction 113 illustrated in FIG. 11.

The number of steps of a simulation is registered in the item of step. An execution time of the corresponding step, for example, a time from an execution start to an execution completion of the step is registered in the item of step_execution_time. A unit of step_execution_time is milliseconds. The number of vehicles that exist in the simulation space 40 in the corresponding step is registered in the item of car_num. An average speed of the vehicle in the corresponding step is registered in the item of car_speed_ave. A unit of car_speed_ave is kilometers per hour (km/h).

For example, the simulation result table 114 has a record of step "1", step_execution_time "15", car_num "326", and car_speed_ave "32.23". This record indicates that an execution time of a first step in the simulation is 15 milliseconds. The record indicates that the number of vehicles that exist in the simulation space 40 is 326 and the average speed of each vehicle is 32.23 km/h, in the first step.

Even for other steps, the simulation result table 114 has records of the execution time of the step, the number of vehicles, and the average speed of the vehicle. Although not illustrated, the simulation result table 114 is associated with a set of values of a parameter. For example, the simulation result table 114 is generated for the set of the values of the parameter to be used in a simulation for a certain number of steps or for a certain time, for example, for each set of a value of a charge area and a value of a charge amount.

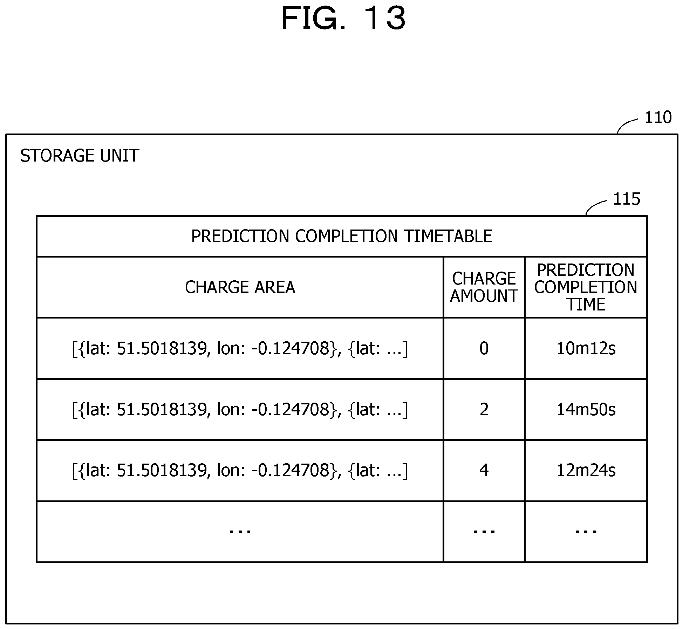

FIG. 13 is a diagram illustrating an example of a prediction completion timetable. A prediction completion timetable 115 is generated by the execution sequence determination unit 123 based on the simulation result table 114 for each set of a value of a charge area and a value of a charge amount, and is stored in the storage unit 110. The prediction completion timetable 115 includes items of the charge area, the charge amount, and a prediction completion time.

The value of the charge area is registered on the item of the charge area. The value of the charge amount is registered on the item of the charge amount. The time T is registered in the item of the prediction completion time. The time T is a time taken to execute a simulation, which is predicted for the set of the value of the corresponding charge area and the value of the charge amount.

For example, the prediction completion timetable 115 has a record of a charge area "[{lat:51.5018139, lon:-0.124708}, {lat:...]", a charge amount "0", and a prediction completion time "10m12s". This record indicates that the prediction completion time T of the simulation for all steps in a case where the value of the charge area is set to "[{lat:51.5018139, lon:-0.124708}, {lat:...]" and the value of the charge amount is set to "0" is 10 minutes and 12 seconds.

The prediction completion timetable 115 also has a record of a prediction completion time for another set of the value of the charge area and the value of the charge amount.

The execution sequence determination unit 123 may calculate the time T by using Equations (1), (3), (5), (7), (8), (9), (10), and the like described above. For example, as indicated by Equation (7) or Equation (8), in a case where the number of route re-searches is used to calculate the time T as information on traffic dynamics, the first execution instruction unit 122 may designate an element name of the number of route re-searches in the result output instruction 113.

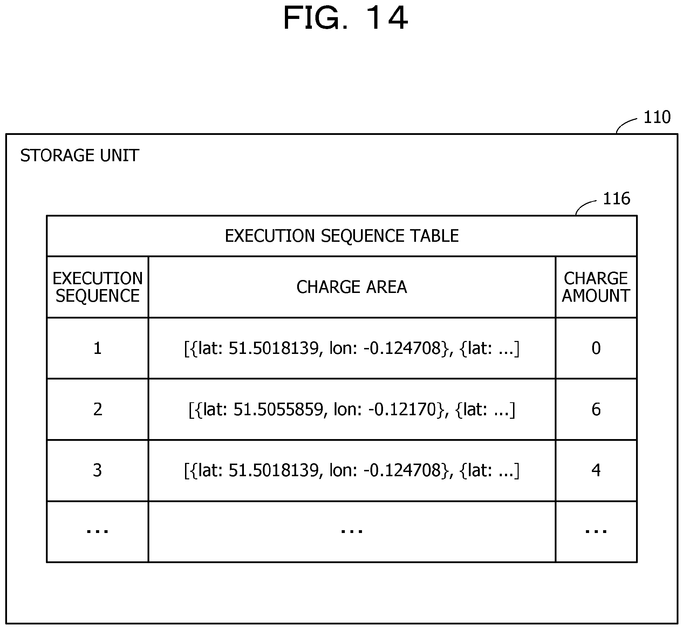

FIG. 14 is a diagram illustrating an example of an execution sequence table. An execution sequence table 116 is generated by the execution sequence determination unit 123 based on the prediction completion timetable 115, and stored in the storage unit 110. The execution sequence table 116 includes items of an execution sequence, a charge area, and a charge amount.

A number indicating an execution sequence for a set of a value of the charge area and a value of the charge amount is registered in the item of the execution sequence. The value of the charge area is registered on the item of the charge area. The value of the charge amount is registered on the item of the charge amount.

For example, the execution sequence table 116 has a record of an execution sequence "1", a charge area "[{lat:51.5018139, lon:-0.124708}, {lat:...]", and a charge amount "0". This record indicates that an execution sequence of a simulation corresponding to a set of a value of the charge area "[{lat:51.5018139, lon:-0.124708}, {lat:...]" and a value of the charge amount "0" is first. Based on the prediction completion timetable 115, the execution sequence determination unit 123 determines the execution sequence such that a set of values of a parameter having a short prediction completion time is executed in an early sequence.

The execution sequence table 116 also has a record of an execution sequence for another set of the value of the charge area and the value of the charge amount.

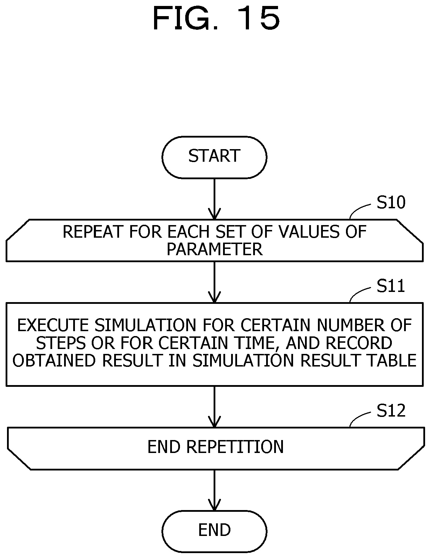

Next, a process procedure of the information processing apparatus 100 will be described. FIG. 15 is a flowchart illustrating an example of acquiring a simulation result table.

(S10) The first execution instruction unit 122 extracts one set of values of each parameter from the policy parameter range information 111 to generate the policy parameter information 112. The first execution instruction unit 122 inputs the policy parameter information 112 and the result output instruction 113 to the simulation execution unit 121, together with information on a certain number of steps or a certain time to be executed, as a preprocess. For each set of the values of the parameter sequentially input to the simulation execution unit 121 by the first execution instruction unit 122, the following operation S11 is repeatedly executed.

(S11) The simulation execution unit 121 executes a simulation for the certain number of steps or for the certain time, and responds to the first execution instruction unit 122 with information according to the result output instruction 113. The first execution instruction unit 122 records the information obtained from the simulation execution unit 121 in the simulation result table 114. As described above, the first execution instruction unit 122 generates the simulation result table 114 for each set of the values of the parameter.

(S12) The first execution instruction unit 122 ends the repetition when all sets of obtainable values of each parameter are extracted. The acquisition of the simulation result table 114 is ended.

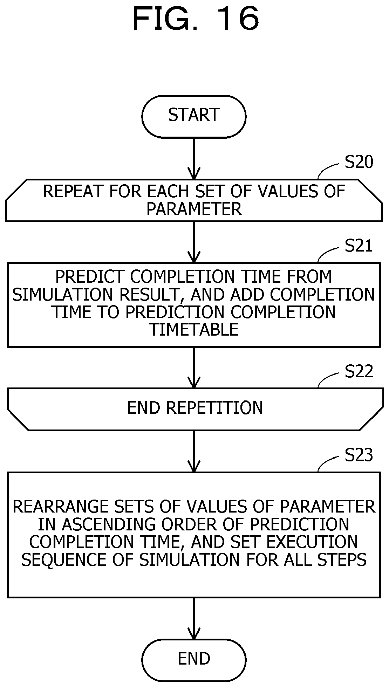

FIG. 16 is a flowchart illustrating an example of determining an execution sequence of a simulation.

(S20) The execution sequence determination unit 123 repeatedly executes the following operation S21 for each set of values of a parameter to be used to execute a simulation for a certain number of steps or for a certain time.

(S21) The execution sequence determination unit 123 predicts, from the simulation result table 114 corresponding to the corresponding set of the values of the parameter, the time T taken to complete the simulation in a case where the set is used, and records the time T in the prediction completion timetable 115. For example, the time T is calculated by the method illustrated in FIG. 8. The predicted time T is recorded in the item of the prediction completion time in the

EP 4 300 347 A1

prediction completion timetable 115.

(S22) After executing operation S21 for all sets of the values of the parameter, the execution sequence determination unit 123 ends the repetition, and the process proceeds to operation S23.

(S23) The execution sequence determination unit 123 rearranges the sets of the values of the parameter in ascending order of prediction completion times of the simulations, based on the prediction completion timetable 115, and sets the sequence as an execution sequence of the simulations for all the steps. According to operation S23, the execution sequence determination unit 123 generates the execution sequence table 116. The execution sequence determination unit 123 determines the execution sequence such that a set of parameter values with a short prediction completion time is executed in an early sequence. The determination of the execution sequence of the simulations is ended.

According to the execution sequence in the execution sequence table 116, the second execution instruction unit 124 instructs the simulation execution unit 121 to execute the simulation of all the steps for the set of the values of the parameter. Every time the simulations of all the steps for the set of the values of the corresponding parameter are completed, the result output unit 125 acquires a simulation result including a predetermined evaluation value and the like from the simulation execution unit 121 and presents the simulation result to the user.

Thus, the information processing apparatus 100 may support the user to grasp an overall tendency of a distribution of the evaluation values or the like for the set of the values of each parameter at a relatively early stage.

As described above, the second execution instruction unit 124 may instruct the simulation execution unit 121 to execute the simulation of each value in all the steps from a beginning. In this case, the simulation execution unit 121 executes the simulation of each value in all the steps from the beginning. Alternatively, a case where the simulation results for a certain number of steps or for a certain time are held in the storage unit 110 may be considered. In this case, the second execution instruction unit 124 may instruct the simulation execution unit 121 to execute the simulation with the corresponding value after the certain number of steps or the certain time. In this case, the simulation execution unit 121 executes the simulation of each value after the certain number of steps or the certain time. In any case, a simulation for which the calculated prediction time is short is preferentially executed after the certain number of steps or the certain time.

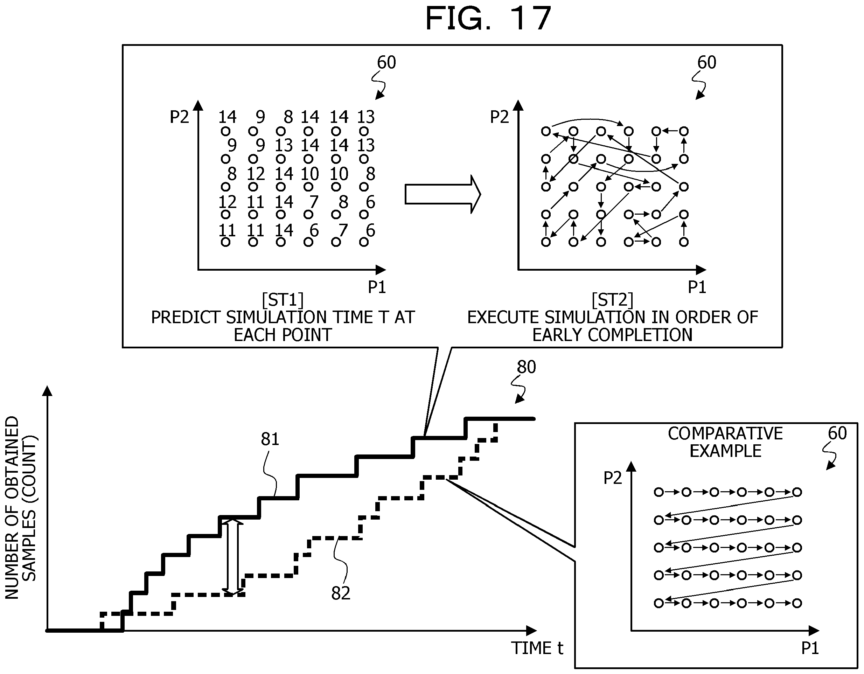

FIG. 17 is a diagram illustrating an example of a relationship between a time and the number of obtained samples. A graph 80 illustrates a relationship between the time t and the number of obtained samples. In the graph 80, a horizontal axis indicates the time t, and a vertical axis indicates the number of samples (count). A sample corresponds to a simulation result such as an evaluation value obtained by simulations of all steps for one set of values of each parameter.

The graph 80 includes a series 81 and a series 82. The series 81 indicates a case where an execution sequence of the sets of the values of the parameter is controlled by the method of the information processing apparatus 100 illustrated in FIGs. 15 and 16. For example, the method of the information processing apparatus 100 includes stages ST1 and ST2. At stage ST1, the control unit 120 predicts the time T taken for the simulation at each point in the parameter space 60 based on a result of executing the simulation for a certain number of steps or for a certain time at each point. At stage ST2, the control unit 120 executes the simulation based on the predicted time T in an order of priority given to a point for which the simulation is to be early completed.

The series 82 is a case where the existing grid search method is simply used without controlling the execution sequence. By the existing grid search method, for example, points in the parameter space 60 are sequentially extracted while being shifted by a regular interval, a simulation is executed, and a simulation result is obtained.

When comparing the series 81 and the series 82, it may be seen that the number of obtained samples in the series 81 is larger than the number of obtained samples in the series 82 at a relatively early stage. For example, the information processing apparatus 100 may acquire simulation results for many sets of the values of each parameter at an early timing.

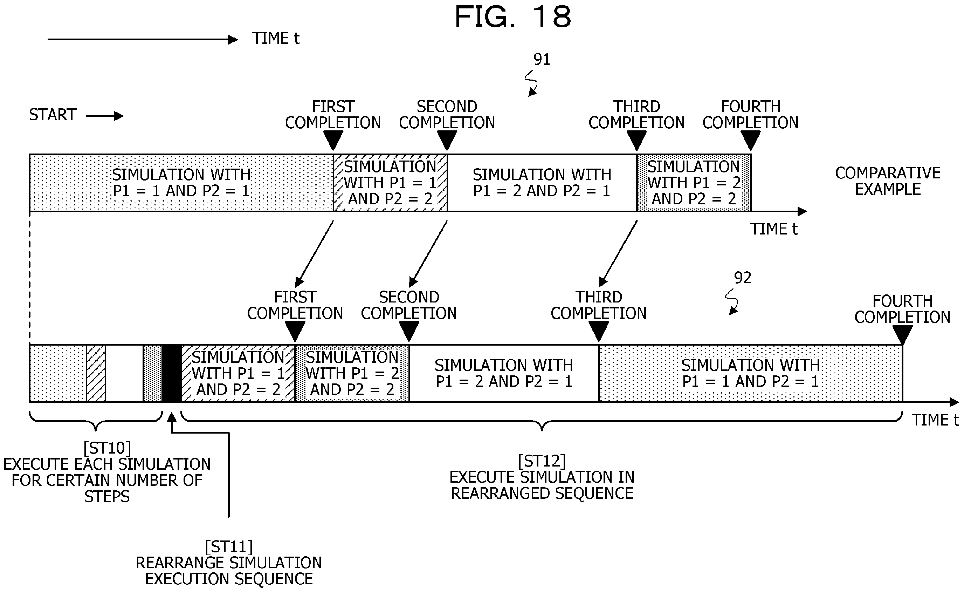

FIG. 18 is a diagram illustrating an execution example of a simulation. Timing charts 91 and 92 represent a timing at which a simulation is executed for a set of values of a parameter, with a direction from left to right in FIG. 18 as a positive direction of the time t. A left end of the timing charts 91 and 92 is a start time point.

The timing chart 91 is a comparative example in a case where the existing grid search method is used. The timing chart 92 illustrates a case where the simulation is executed by controlling an execution sequence by the method of the information processing apparatus 100. For simplification of description, a set of obtainable values of the parameters P1 and P2 is assumed here to be (P1, P2) = (1, 1), (1, 2), (2, 1), and (2, 2). The timing chart 91 illustrates an example in which the simulation is performed in this order. According to the example of the timing chart 92, the control unit 120 sequentially executes stages ST10, ST11, and ST12.

At stage ST10, the control unit 120 executes the simulation for each of the sets of the values of the parameter (1, 1), (1, 2), (2, 1), and (2, 2) for a certain number of steps (or a certain time).

At stage ST11, the control unit 120 rearranges the simulation execution sequence of the sets of the values of the parameter, based on information on traffic dynamics obtained by executing the simulation for the certain number of steps or for the certain time. For example, the control unit 120 rearranges the execution sequence in an order of (P1, P2) = (1, 2), (2, 2), (2, 1), and (1, 1).

At stage ST12, the control unit 120 executes the simulation in the rearranged sequence. For example, the control unit 120 executes the simulation in the order of (P1, P2) = (1, 2), (2, 2), (2, 1), and (1, 1) determined in stage ST11. When comparing the timing charts 91 and 92, simulation results of the first to third sets of the values of each parameter are obtained earlier in the timing chart 92 than in the timing chart 91.

In this manner, the information processing apparatus 100 postpones the simulation for a set of values of a parameter predicted to take a relatively long time, and thus may quickly obtain the simulation results for many sets of the values of the parameter.

The information processing apparatus 100 may support a user to grasp an overall tendency of an evaluation value or the like obtained as a result of the simulation at an earlier stage than the existing method. The information processing apparatus 10 may support early determination such as interruption of the simulation, and may also suppress a cost for the calculation.

Third Embodiment

Next, a third embodiment will be described. Items in the third embodiment different from the second embodiment will be mainly described below while omitting descriptions of the common items.

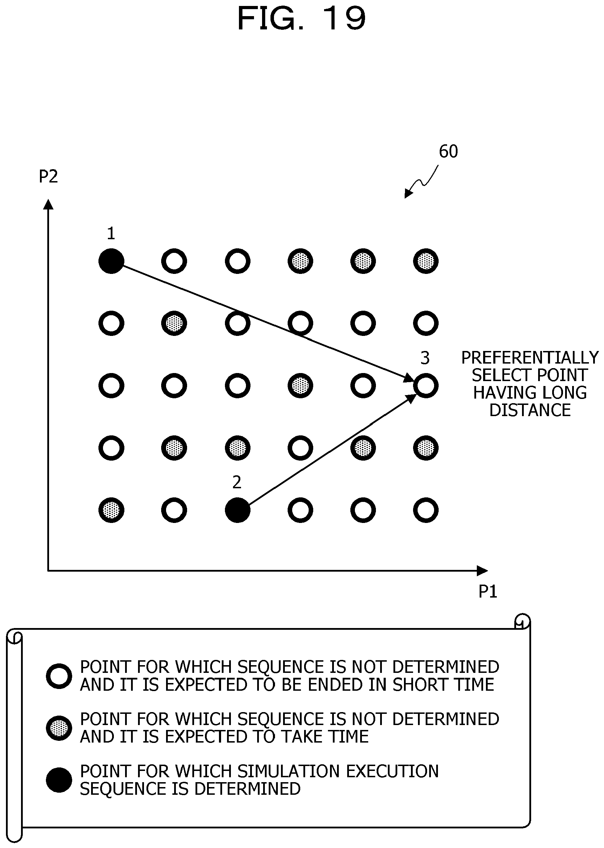

FIG. 19 is a diagram illustrating an example of determining an execution sequence according to the third embodiment. According to the third embodiment, the execution sequence determination unit 123 considers a distance between respective points in the parameter space 60, in addition to the time T taken to execute a simulation for each point. For example, one point in the parameter space 60 corresponds to one set of a value of the parameter P1 and a value of the parameter P2. For example, the points in the parameter space 60 are classified into three types, in accordance with a progress of the processes of the execution sequence determination unit 123.

A first classification is that an execution sequence of a simulation is not determined and the simulation is expected to be ended in a short time at a point. A second classification is that the execution sequence of the simulation is not determined and it is expected that the simulation takes time at a point. A third classification is that the simulation execution sequence is determined at a point.

The execution sequence determination unit 123 determines an execution sequence such that a simulation for a point for which the predicted time T is short and a distance from a point for which the execution sequence is determined is long is preferentially executed. For example, the execution sequence determination unit 123 calculates a priority score Priority ($p_k$) for a point $p_k$ for which the execution sequence is not determined in the parameter space 60, based on the time T and a distance between specific points in the parameter space 60. k is an index for identifying a point for which the execution sequence is not determined. Based on Priority ($p_k$), the execution sequence determination unit 123 determines the execution sequence. For example, the priority score Priority ($p_k$) is calculated by Equation (11).

$$Priority(\mathbf{p}_k) = A \cdot \frac{\min_{\mathbf{p} \in \mathbf{P}_{Done}} \|\mathbf{p} - \mathbf{p}_k\|}{T_k} \qquad (11)$$

A is a positive coefficient given in advance. $P_{Done}$ is a set of points for which an execution sequence is determined. p is an element of $P_{Done}$. $\min\|p - p_k\|$ indicates a smallest value among p - $p_k$(p ∈ $P_{Done}$). $T_k$ is a time taken to execute a simulation, which is calculated for $p_k$. As a value of the priority score Priority ($p_k$) is larger, the degree of priority is higher.

By using the priority score Priority ($p_k$), the execution sequence determination unit 123 preferentially selects, for example, a point having the relatively short time T and a long distance from points with the labels "1" and "2", with respect to points with the labels "1" and "2" for which an execution sequence is determined, in the parameter space 60. The execution sequence determination unit 123 may select a point separated from the point, for which the execution sequence is determined, by some extent, as a point to be used for the next simulation execution.

Thus, among the executed parameters, a parameter having the longest distance to a parameter with the shortest distance, for example, a parameter farther than any parameter executed so far is given priority. The coefficient A is selected in advance in accordance with a use. For example, by setting A > 1, the distance $\min\|p - p_k\|$ between the respective values of the parameters is prioritized (weight of the distance is increased). By setting 0 < A < 1, the time $T_k$ of the simulation is prioritized (weight of the time is increased).

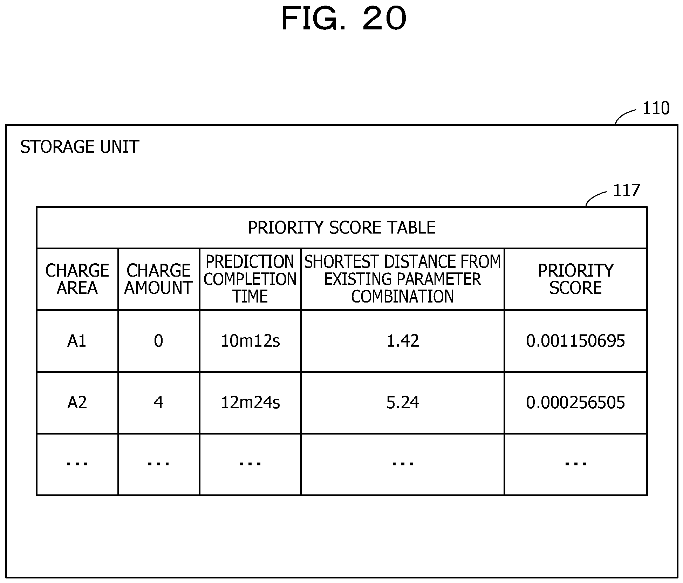

FIG. 20 is a diagram illustrating an example of a priority score table. According to the third embodiment, a priority score table 117 is used, instead of the prediction completion timetable 115. The priority score table 117 is generated by the execution sequence determination unit 123, and stored in the storage unit 110. The priority score table 117 includes items of a charge area, a charge amount, a prediction completion time, a shortest distance from an existing parameter combination, and a priority score.

A value of the charge area is registered on the item of the charge area. A value of the charge amount is registered on the item of the charge amount. The time T taken to execute a simulation of all steps for a set of the value of the charge area and the value of the charge amount is registered in the item of the prediction completion time. A shortest distance $\min\|p - p_k\|$ from a set of values of a parameter for which an execution sequence of a simulation is determined is registered in the item of the shortest distance from the existing parameter combination. A priority score calculated based on Equation (11) is registered in the item of the priority score.

For example, the priority score table 117 has a record of a charge area "A1", a charge amount "0", a prediction completion time "10m12s", a shortest distance "1.42" from an existing parameter combination, and a priority score "0.001150695". Although the value of the charge area is abbreviated as "A1" in the example in FIG. 20, the value of the charge area is represented by a combination of coordinates (latitudes and longitudes) indicating vertices of a polygon as described above.

This record indicates that the time T is 10 minutes and 12 seconds for a set of the charge area "A1" and the charge amount "0". The record indicates that the shortest distance $\min\|p - p_k\|$ of a point corresponding to the set of the charge area "A1" and the charge amount "0" from a point corresponding to the set of the values of the parameter for which the execution sequence of the simulation is determined is 1.42. In the record, a priority score calculated by Equation (11) for the time T = 10 minutes and 12 seconds and $\min\|p - p_k\|$ = 1.42 indicates "0.001150695".

The priority score table 117 has a record indicating a priority score also for another set of the value of the charge area and the value of the charge amount.

Next, a process procedure of the information processing apparatus 100 according to the third embodiment will be described. A procedure of acquiring the simulation result table 114 has the same manner as the procedure illustrated in FIG. 15, and thus description thereof will be omitted.

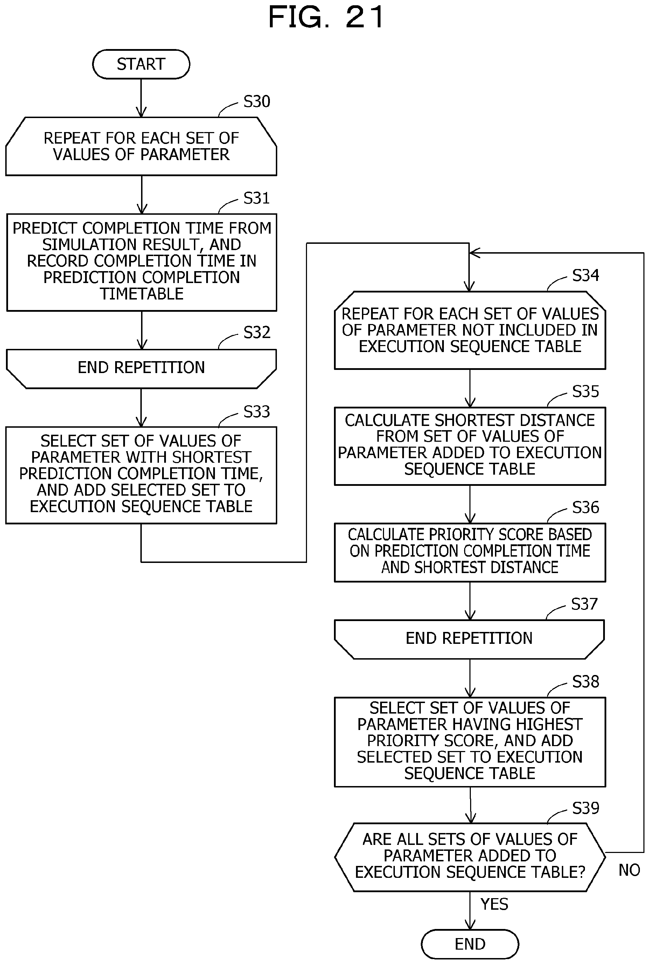

FIG. 21 is a flowchart illustrating an example of determining an execution sequence of a simulation.

(S30) The execution sequence determination unit 123 repeatedly executes the following operation S31 for each set of values of a parameter to be used to execute a simulation for a certain number of steps or for a certain time.

(S31) The execution sequence determination unit 123 predicts, from the simulation result table 114 corresponding to the corresponding set of the values of each parameter, the time T taken to complete the simulation in a case where the set is used, and records the predicted time T in the priority score table 117. For example, the time T is calculated by the method illustrated in FIG. 8. The predicted time T is recorded in an item of a prediction completion time in the priority score table 117.

(S32) After executing operation S31 for all combinations of the values of the parameter, the execution sequence determination unit 123 ends the repetition, and the process proceeds to operation S33.

(S33) The execution sequence determination unit 123 selects a set of values of a parameter with the shortest prediction completion time of the simulation, based on the priority score table 117, and adds the set in the execution sequence table 116. The set of the values of the parameter selected in operation S33 has an execution sequence of "1". After that, every time a set of values of a parameter is added to the execution sequence table 116, the execution sequences "2", "3", and ... are assigned. The execution sequence determination unit 123 deletes a record of the set of the values of the parameter for which the execution sequence is determined from the priority score table 117.

(S34) The execution sequence determination unit 123 repeatedly executes operations S35 and S36 for each set of values of a parameter not included in the execution sequence table 116. The set of the values of the parameter used in operations S35 and S36 and not included in the execution sequence table 116 corresponds to the point $p_k$ in the parameter space 60. The set of the values of the parameter included in the execution sequence table 116 corresponds to a point $p \in P_{Done}$ in the parameter space 60.

(S35) The execution sequence determination unit 123 determines, for a set of values of the corresponding parameter for which the execution sequence is not determined (corresponding to the point $p_k$), a shortest distance from the set of the values of the parameter that is added to the execution sequence table 116, and records the shortest distance in the priority score table 117. The shortest distance corresponds to $\min\|p - p_k\|(p \in P_{Done})$ in Equation (11).

(S36) The execution sequence determination unit 123 calculates the priority score Priority ($p_k$) based on Equation (11) from the prediction completion time $T_k$ and the shortest distance $\min\|p - p_k\|$. The execution sequence determination unit 123 registers the calculated priority score Priority ($p_k$) in the priority score table 117 in association with the set of the values of the parameter corresponding to $p_k$.

(S37) When operations S35 and S36 are executed for all the sets of the values of the parameter not included in the execution sequence table 116, the execution sequence determination unit 123 ends the repetition, and the process proceeds to operation S38.

(S38) The execution sequence determination unit 123 selects a set of values of a parameter having the highest priority score based on the priority score table 117, and adds the selected set in the execution sequence table 116. The execution sequence determination unit 123 deletes a record of the set of the values of the parameter for which the execution sequence is determined from the priority score table 117.

(S39) The execution sequence determination unit 123 determines whether or not all the sets of the values of the parameter are added to the execution sequence table 116. In a case where there is a set of values of a parameter that is not added in the execution sequence table 116, the process proceeds to operation S34. In a case where all the sets of the values of the parameter are added to the execution sequence table 116, the determination of the execution sequence of the simulation is ended.

According to the execution sequence in the execution sequence table 116, the second execution instruction unit 124 instructs the simulation execution unit 121 to execute the simulation of all the steps (or a certain number of steps or a certain time or later) for the sets of the values of the parameter. Every time the simulations of all the steps for the set of the values of the corresponding parameter are completed, the result output unit 125 acquires a simulation result including a predetermined evaluation value and the like from the simulation execution unit 121 and presents the simulation result to the user.

Thus, the information processing apparatus 100 may support the user to grasp an overall tendency of a distribution of the evaluation values or the like for the set of the values of each parameter at a relatively early stage. For example, when a simulation with a small amount of calculation is simply executed by priority, only a part of the parameter space 60 may be calculated, and in this case, it is difficult to grasp an entire distribution of evaluation values and the like at an early stage. The information processing apparatus 100 suppresses the calculation of only the part of the parameter space 60, by adding correction based on a distance from a parameter for which the simulation is executed to a priority of the execution sequence of the simulation based on the execution time of the simulation. As a result, the information processing apparatus 100 may easily grasp the entire distribution at an early stage.

As described above, the information processing apparatus 100 executes the following process. The control unit 120 executes a simulation of traffic dynamics by moving objects a plurality of times while changing a value of a parameter. At this time, the control unit 120 executes each simulation for a certain number of steps or for a certain time. Based on information indicating the traffic dynamics obtained by the executed simulation, the control unit 120 calculates the prediction time T taken for completion of each simulation. Among the respective simulations, the control unit 120 preferentially executes a simulation for which the calculated prediction time T is short, after the certain number of steps or the certain time.

Thus, the information processing apparatus 100 may acquire simulation results for many values at an early timing. The information processing apparatus 100 may grasp an entire distribution of the simulation results indicating evaluation values and the like at a relatively early stage. A process performed by the information processing apparatus 100 may be described as follows.

For each of a plurality of values of a parameter, the control unit 120 executes a simulation of traffic dynamics by moving objects for a certain number of steps or for a certain time. Based on information indicating the traffic dynamics obtained by the simulation for the certain number of steps or for the certain time, the control unit 120 predicts a time T taken to complete the simulation for each of the plurality of values. The prediction of the time T has the same manner as calculation of the prediction time T. Among the plurality of values, the control unit 120 preferentially executes a simulation for which the predicted time T is a short value.

Thus, the information processing apparatus 100 may acquire simulation results for many values at an early timing. The information processing apparatus 100 may grasp an entire distribution of the simulation results indicating evaluation values and the like at a relatively early stage. The moving object may be a vehicle such as an automobile, a railway vehicle, or a bicycle. The moving object may be a ship or an airplane. The moving object may be a person. One parameter or a plurality of parameters may be used. In a case where the number of parameters is one, values of the parameter are plotted in one-dimensional parameter space. In a case where the number of parameters is N (N is an integer equal to or more than 2), a set of values of N parameters is plotted in an N-dimensional parameter space.

For example, the information indicating the traffic dynamics may be at least one of a speed of the moving object, the number of moving objects, and the number of route re-searches by the moving object. For example, the control unit 120 may acquire, as the information indicating the traffic dynamics, at least one of the speed of the moving object, the number of moving objects, and the number of route re-searches by the moving object. In this manner, the information processing apparatus 100 may appropriately predict the time T by using an index that affects a time taken to complete the simulation as the information indicating the traffic dynamics.

For example, the "number of moving objects" is the number of moving objects existing in the simulation space 40 for each step in the simulation, for example, the number of moving objects processed for each step.

The control unit 120 may predict the time T, based on at least one of an average speed of the moving object, an average value of the number of moving objects per step, and an average value of the number of route re-searches per step, which are processed by the simulation for a certain number of steps or for a certain time. Thus, the information processing apparatus 100 may improve accuracy of the prediction of the time T. For example, the control unit 120 may use Equations (1), (3), (5), (7), (8), and the like, for the prediction of the time T.

In the prediction of the time T, the control unit 120 may correct the time T calculated based on the information indicating the traffic dynamics, based on a first time taken to execute the simulation with a certain number of steps or a first number of steps executed in the simulation for a certain time. Thus, the information processing apparatus 100 may improve accuracy of the prediction of the time T. For example, the control unit 120 may use Equation (9), Equation (10), and the like to correct the time T.

The control unit 120 may execute the following process when determining an execution sequence of the simulation based on the predicted time T. The control unit 120 may calculate a priority according to a shortest distance between a value for which an execution sequence of each value of the parameter is determined and a first value for which the execution sequence of each value of the parameter is not determined, and the time T predicted for the first value, for each of a plurality of first values. Based on the calculated priority, the control unit 120 may determine the first value to be used for the next execution of the simulation.

Thus, the information processing apparatus 100 may more appropriately determine the execution sequence for each value of the parameter. For example, the control unit 120 may use Equation (11) to calculate the priority. For example, based on the priority, the control unit 120 preferentially executes a simulation for a first value for which the time T is short and the shortest distance is long described above among each of the plurality of first values. Thus, the information processing apparatus 100 may suppress the simulation from being executed in a narrow range of the parameter space, and may grasp the entire distribution of the simulation results indicating the evaluation values and the like at a relatively early stage.

A plurality of parameters may be used. The control unit 120 may execute the simulation by using each of a plurality of sets of values of the plurality of parameters for a certain number of steps or for a certain time. Based on the information indicating the traffic dynamics obtained by the simulation using each of the plurality of sets, the control unit 120 may calculate the prediction time T for each simulation.

For example, the control unit 120 may execute the simulation for the certain number of steps or for the certain time, for each of the plurality of sets of the values of the plurality of parameters. Based on the information indicating the traffic dynamics obtained by the simulation for the certain number of steps or for the certain time, the control unit 120 may predict the time T for each of the plurality of sets. Among the plurality of sets, the control unit 120 may preferentially execute a simulation for a set for which the predicted time T is short.

Thus, the information processing apparatus 100 may acquire simulation results for many sets of values at an early timing. The information processing apparatus 100 may grasp an entire distribution of the simulation results indicating evaluation values and the like at a relatively early stage.

The information processing according to the first embodiment may be implemented by causing the processing unit 12 to execute a program. The information processing according to the second and the third embodiments may be implemented by causing the CPU 101 to execute a program. The program may be recorded in a computer-readable recording medium 33.

For example, the program may be circulated by distributing the recording medium 33 in which the program is recorded. The program may be stored in another computer, and the program may be distributed via a network. For example, a computer may store (install), in a storage device such as the RAM 102 or the HDD 103, the program recorded in the recording medium 33 or the program received from the another computer, and may read the program from the storage device to execute the program.

**Claims**

1. A simulation execution method in which a computer executes simulations of traffic dynamics of a moving object a plurality of times by changing a value of a parameter, the simulation execution method comprising:

   executing each of the simulations for one of a predetermined number of steps and a predetermined time;
   obtaining a prediction time taken for completion of each of the simulations, based on information that indicates the traffic dynamics obtained by the executed simulation; and
   preferentially executing, among each of the simulations, a simulation for which the obtained prediction time is short, after the one of the predetermined number of steps and the predetermined time.

2. The simulation execution method according to claim 1,
   wherein the information includes at least one of a speed of the moving object, a number of the moving objects, and a number of route re-searches of the moving object.

3. The simulation execution method according to claim 2,
   wherein, in the obtaining of the prediction time, the prediction time is obtained based on at least one of an average speed of the moving object, an average value of the number of the moving objects per step, and an average value of the number of the route re-searches per step, which are processed by the simulation for the one of the predetermined number of steps and the predetermined time.

4. The simulation execution method according to claim 1,
wherein, in the obtaining of the prediction time, the prediction time obtained based on the information is corrected based on one of a first time taken to execute the simulation for the predetermined number of steps and a first number of steps executed in the simulation for the predetermined time.

5. The simulation execution method according to claim 1,
wherein, when an execution sequence of the simulations is determined based on the prediction time, a priority according to a shortest distance between a value for which the execution sequence is determined among values of the parameter and a first value for which the execution sequence is not determined among the values of the parameter, and according to the prediction time predicted for the first value is obtained for each of a plurality of first values, and the first value to be used for a next execution of the simulation is determined based on the priority, the plurality of first values including the first value.

6. The simulation execution method according to claim 5,
Wherein, among the plurality of first values, the simulation with the first value for which the prediction time is shortest and the shortest distance is longest is preferentially executed based on the priority.

7. The simulation execution method according to claim 1,

wherein the simulation that uses each of a plurality of sets of values of a plurality of parameters is executed for one of the predetermined number of steps and the predetermined time, the plurality of parameters including the parameter, and

wherein the prediction time is obtained for each of the simulations, based on the information obtained by the simulation that uses each of the plurality of sets.

8. A program for causing a computer to execute a process of simulations of traffic dynamics of a moving object a plurality of times by changing a value of a parameter, the process comprising:

executing each of the simulations for one of a predetermined number of steps and a predetermined time;
obtaining a prediction time taken for completion of each of the simulations, based on information that indicates the traffic dynamics obtained by the executed simulation; and
preferentially executing, among each of the simulations, a simulation for which the obtained prediction time is short, after the one of the predetermined number of steps and the predetermined time.

# FIG. 1

INFORMATION PROCESSING APPARATUS 10

STORAGE UNIT 11 — PROCESSING UNIT 12

PARAMETER SPACE 20

P2

| 14 | 9 | 8 | 14 | 14 | 13 |
| 9 | 9 | 13 | 14 | 14 | 13 |
| 8 | 12 | 14 | 10 | 10 | 8 |
| 12 | 11 | 14 | 7 | 8 | 6 |
| 11 | 11 | 14 | 6 | 7 | 6 |

P1

[S1]
PREDICT SIMULATION TIME T
AT EACH POINT

20

P2

P1

[S2]
EXECUTE SIMULATION BY
PRIORITIZING POINT FOR
WHICH TIME T IS SHORT

# FIG. 2

INFORMATION PROCESSING APPARATUS 100

CPU 101

RAM 102

HDD 103

GPU 104 — 31

INPUT INTERFACE 105 — 32

MEDIUM READER 106 — 33

NIC 107 — NETWORK 34

# FIG. 3

EXAMPLE OF DISTRIBUTION OF EVALUATION VALUES
FOR PARAMETER SPACE

EXAMPLE OF CHARGE AREA IN ROAD PRICING
POLICY EVALUATION

CHARGE AREA SIZE P2

50

SAFETY BAD
$CO_2$ EMISSION GOOD
REGIONAL ECONOMY BAD

SAFETY BAD
$CO_2$ EMISSION BAD
REGIONAL ECONOMY
GOOD

SAFETY GOOD
$CO_2$ EMISSION BAD
REGIONAL ECONOMY BAD

CHARGE
AMOUNT P1

40

41

EP 4 300 347 A1

# FIG. 4A

GRID SEARCH METHOD

60

P2

P1

ALL OVER SEARCH

# FIG. 4B

RANDOM SEARCH METHOD

60

P2

P1

RANDOM SEARCH

# FIG. 5

INFORMATION PROCESSING APPARATUS · 100

CONTROL UNIT · 120

FIRST EXECUTION INSTRUCTION UNIT · 122

EXECUTION SEQUENCE DETERMINATION UNIT · 123

SECOND EXECUTION INSTRUCTION UNIT · 124

RESULT OUTPUT UNIT · 125

STORAGE UNIT · 110

SIMULATION EXECUTION UNIT · 121

# FIG. 6

START WITH m VEHICLES
ADD n VEHICLES AT
PREDETERMINED TIME INTERVALS

WITH P1 = 1 AND P2 = 1
AFTER CERTAIN NUMBER
OF STEPS

IN CASE OF TRAFFIC CONGESTION,
INCREASE IN NUMBER OF VEHICLES →
INCREASE IN CALCULATION TIME

WITH P1 = 1 AND P2 = 2
AFTER CERTAIN NUMBER
OF STEPS

IN CASE OF SMOOTHNESS, DECREASE IN NUMBER OF
VEHICLES or FIXED → DECREASE IN CALCULATION TIME

EP 4 300 347 A1

# FIG. 7

# FIG. 8

# FIG. 9

110

STORAGE UNIT

111

| POLICY PARAMETER RANGE INFORMATION | |
|---|---|
| PARAMETER NAME | VALUE |
| CHARGE AREA | [ [ {lat: 51.5018139, lon: -0.124708}, {lat: ... ], [ {lat: 51.5055859, lon: -0.12172}, {lat: ...] ] |
| CHARGE AMOUNT | [0, 2, 4, 6, 8, 10] |

# FIG. 10

110

STORAGE UNIT

112

| POLICY PARAMETER INFORMATION | |
|---|---|
| PARAMETER NAME | VALUE |
| CHARGE AREA | [ {lat: 51.5018139, lon: -0.124708}, {lat: ... ] |
| CHARGE AMOUNT | 4 |

# FIG. 11

110

STORAGE UNIT

113

| RESULT OUTPUT INSTRUCTION |
| --- |
| OUTPUT ELEMENT NAME |
| step_execution_time (STEP EXECUTION TIME) |
| car_num (NUMBER OF VEHICLES) |
| car_speed_ave (VEHICLE AVERAGE SPEED) |

# FIG. 12

**110**

STORAGE UNIT

**114**

| SIMULATION RESULT TABLE | | | |
|---|---|---|---|
| step | step_execution_time (MILLISECONDS) | car_num | car_speed_ave （km/h） |
| 1 | 15 | 326 | 32.23 |
| 2 | 12 | 327 | 32.54 |
| 3 | 11 | 327 | 33.01 |
| ... | ... | ... | ... |

# FIG. 13

110

STORAGE UNIT

115

| PREDICTION COMPLETION TIMETABLE | | |
|---|---|---|
| CHARGE AREA | CHARGE AMOUNT | PREDICTION COMPLETION TIME |
| [{lat: 51.5018139, lon: -0.124708}, {lat: ...] | 0 | 10m12s |
| [{lat: 51.5018139, lon: -0.124708}, {lat: ...] | 2 | 14m50s |
| [{lat: 51.5018139, lon: -0.124708}, {lat: ...] | 4 | 12m24s |
| ... | ... | ... |

# FIG. 14

110

STORAGE UNIT

116

| EXECUTION SEQUENCE TABLE | | |
|---|---|---|
| EXECUTION SEQUENCE | CHARGE AREA | CHARGE AMOUNT |
| 1 | [{lat: 51.5018139, lon: -0.124708}, {lat: ...] | 0 |
| 2 | [{lat: 51.5055859, lon: -0.12170}, {lat: ...] | 6 |
| 3 | [{lat: 51.5018139, lon: -0.124708}, {lat: ...] | 4 |
| ... | ... | ... |

# FIG. 15

START

S10

REPEAT FOR EACH SET OF VALUES OF PARAMETER

S11

EXECUTE SIMULATION FOR CERTAIN NUMBER OF STEPS OR FOR CERTAIN TIME, AND RECORD OBTAINED RESULT IN SIMULATION RESULT TABLE

S12

END REPETITION

END

# FIG. 16

```
        ┌─────────────┐
        │    START    │
        └─────────────┘
               │
               ▼                              ⌒ S20
  ╱─────────────────────────────────╲
  │   REPEAT FOR EACH SET OF VALUES OF │
  │            PARAMETER               │
  ╲─────────────────────────────────╱
               │
               ▼                              ⌒ S21
  ┌───────────────────────────────────┐
  │     PREDICT COMPLETION TIME FROM   │
  │ SIMULATION RESULT, AND ADD COMPLETION │
  │   TIME TO PREDICTION COMPLETION    │
  │            TIMETABLE               │
  └───────────────────────────────────┘
               │
               ▼                              ⌒ S22
  ╱─────────────────────────────────╲
  │        END REPETITION             │
  ╲─────────────────────────────────╱
               │
               ▼                              ⌒ S23
  ┌───────────────────────────────────┐
  │ REARRANGE SETS OF VALUES OF PARAMETER │
  │  IN ASCENDING ORDER OF PREDICTION  │
  │   COMPLETION TIME, AND SET EXECUTION │
  │ SEQUENCE OF SIMULATION FOR ALL STEPS │
  └───────────────────────────────────┘
               │
               ▼
        ┌─────────────┐
        │     END     │
        └─────────────┘
```

# FIG. 17

[ST1]
PREDICT SIMULATION TIME T AT EACH POINT

[ST2]
EXECUTE SIMULATION IN ORDER OF EARLY COMPLETION

COMPARATIVE EXAMPLE

# FIG. 18

TIME t →

START →

**91**

FIRST COMPLETION  SECOND COMPLETION  THIRD COMPLETION  FOURTH COMPLETION

SIMULATION WITH P1 = 1 AND P2 = 1 | SIMULATION WITH P1 = 1 AND P2 = 2 | SIMULATION WITH P1 = 2 AND P2 = 1 | SIMULATION WITH P1 = 2 AND P2 = 2

COMPARATIVE EXAMPLE

TIME t

**92**

FIRST COMPLETION  SECOND COMPLETION  THIRD COMPLETION  FOURTH COMPLETION

SIMULATION WITH P1 = 1 AND P2 = 2 | SIMULATION WITH P1 = 2 AND P2 = 2 | SIMULATION WITH P1 = 2 AND P2 = 1 | SIMULATION WITH P1 = 1 AND P2 = 1

TIME t

[ST10]
EXECUTE EACH SIMULATION FOR CERTAIN NUMBER OF STEPS

[ST11]
REARRANGE SIMULATION EXECUTION SEQUENCE

[ST12]
EXECUTE SIMULATION IN REARRANGED SEQUENCE

EP 4 300 347 A1

# FIG. 19

60

P2

1

3  PREFERENTIALLY
SELECT POINT
HAVING LONG
DISTANCE

2

P1

○ POINT FOR WHICH SEQUENCE IS NOT DETERMINED
AND IT IS EXPECTED TO BE ENDED IN SHORT TIME

◉ POINT FOR WHICH SEQUENCE IS NOT DETERMINED
AND IT IS EXPECTED TO TAKE TIME

● POINT FOR WHICH SIMULATION EXECUTION
SEQUENCE IS DETERMINED

# FIG. 20

110

STORAGE UNIT

117

| PRIORITY SCORE TABLE | | | | |
|---|---|---|---|---|
| CHARGE AREA | CHARGE AMOUNT | PREDICTION COMPLETION TIME | SHORTEST DISTANCE FROM EXISTING PARAMETER COMBINATION | PRIORITY SCORE |
| A1 | 0 | 10m12s | 1.42 | 0.001150695 |
| A2 | 4 | 12m24s | 5.24 | 0.000256505 |
| ... | ... | ... | ... | ... |

# FIG. 21

START

S30

REPEAT FOR EACH SET OF
VALUES OF PARAMETER

S31

PREDICT COMPLETION TIME FROM
SIMULATION RESULT, AND
RECORD COMPLETION TIME IN
PREDICTION COMPLETION
TIMETABLE

S32

END REPETITION

S33

SELECT SET OF VALUES OF
PARAMETER WITH SHORTEST
PREDICTION COMPLETION TIME,
AND ADD SELECTED SET TO
EXECUTION SEQUENCE TABLE

S34

REPEAT FOR EACH SET OF VALUES
OF PARAMETER NOT INCLUDED IN
EXECUTION SEQUENCE TABLE

S35

CALCULATE SHORTEST DISTANCE
FROM SET OF VALUES OF
PARAMETER ADDED TO EXECUTION
SEQUENCE TABLE

S36

CALCULATE PRIORITY SCORE BASED
ON PREDICTION COMPLETION TIME
AND SHORTEST DISTANCE

S37

END REPETITION

S38

SELECT SET OF VALUES OF
PARAMETER HAVING HIGHEST
PRIORITY SCORE, AND ADD
SELECTED SET TO EXECUTION
SEQUENCE TABLE

S39

ARE ALL SETS OF VALUES OF
PARAMETER ADDED TO
EXECUTION SEQUENCE TABLE?

NO

YES

END

Europäisches
Patentamt

European
Patent Office

Office européen
des brevets

# EUROPEAN SEARCH REPORT

Application Number

EP 23 16 9756

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2021/174206 A1 (OSKOOI ARDAVAN [US] ET AL) 10 June 2021 (2021-06-10) * abstract; figure 6 * ----- | 1-8 | INV. G06F30/20 G08G1/01 |
| X | WO 2019/203822 A1 (LANDMARK GRAPHICS CORP [US]) 24 October 2019 (2019-10-24) * paragraph [0029] - paragraph [0034]; figure 5 * * paragraph [0020]; figure 2 * ----- | 1-8 | |
| A | EP 2 665 050 A1 (MITSUBISHI HEAVY IND LTD [JP]) 20 November 2013 (2013-11-20) * abstract; figures 5-7 * ----- | 1-8 | |

| | |
|---|---|
| | TECHNICAL FIELDS SEARCHED (IPC) |
| | G06F G08G |

The present search report has been drawn up for all claims

| Place of search | Date of completion of the search | Examiner |
|---|---|---|
| Munich | 15 November 2023 | Ross, Christopher |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 9756

This annex lists the patent family members relating to the patent documents cited in the above-mentioned European search report.
The members are as contained in the European Patent Office EDP file on
The European Patent Office is in no way liable for these particulars which are merely given for the purpose of information.

15-11-2023

| Patent document cited in search report | | Publication date | Patent family member(s) | | Publication date |
|---|---|---|---|---|---|
| US 2021174206 | A1 | 10-06-2021 | US 2021174206 A1 | | 10-06-2021 |
| | | | WO 2021113668 A1 | | 10-06-2021 |
| WO 2019203822 | A1 | 24-10-2019 | CA 3090095 A1 | | 24-10-2019 |
| | | | FR 3080477 A1 | | 25-10-2019 |
| | | | GB 2584559 A | | 09-12-2020 |
| | | | US 2021019189 A1 | | 21-01-2021 |
| | | | WO 2019203822 A1 | | 24-10-2019 |
| EP 2665050 | A1 | 20-11-2013 | BR 112013017713 A2 | | 11-10-2016 |
| | | | CN 103299353 A | | 11-09-2013 |
| | | | EP 2665050 A1 | | 20-11-2013 |
| | | | JP 5325241 B2 | | 23-10-2013 |
| | | | JP 2012146256 A | | 02-08-2012 |
| | | | MY 160645 A | | 15-03-2017 |
| | | | SG 191753 A1 | | 30-08-2013 |
| | | | WO 2012096063 A1 | | 19-07-2012 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019152986 A